(19) Europäisches Patentamt
European Patent Office
Office européen des brevets

(11) **EP 2 104 251 A2**

(12) **EUROPEAN PATENT APPLICATION**

(43) Date of publication:
**23.09.2009 Bulletin 2009/39**

(51) Int Cl.:
*H04B 17/00* (2006.01)    *H04B 5/00* (2006.01)

(21) Application number: **08167974.8**

(22) Date of filing: **30.10.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **17.03.2008  JP 2008068172**

(71) Applicant: **Fujitsu Limited**
**Kawasaki-shi, Kanagawa 211-8588 (JP)**

(72) Inventor: **Sato, Kazuhiro**
**Yokohama-shi, Kanagawa 226-0002 (JP)**

(74) Representative: **Kreutzer, Ulrich et al**
**Cabinet Beau de Loménie**
**Bavariaring 26**
**80336 München (DE)**

(54) **Device and method for testing**

(57)    A control device (300) that specifies an output level to a reader/writer configured to supply an electrical signal corresponding to a radio signal to a stripline cell for transmitting the radio signal to an RFID tag and that has unique output characteristics. The control device (300) includes a response analyzing section (310) that checks the existence of a reaction in the RFID tag; and a distance calculation processing section (312) that uses the output characteristics of the reader/writer from the output level specified to the reader/writer to obtain an electric field strength of the radio signal received by the RFID tag and that converts the electric field strength to a distance between a predetermined antenna and the RFID tag, the antenna transmitting the radio signal with a predetermined output and the RFID tag receiving the radio signal at a same electric field strength as the electric field strength.

FIG. 3

## Description

FIELD

Embodiments discussed herein are directed to a testing device for testing the performance of an electronic device that receives and reacts to a predetermined radio signal and a testing method of such a performance testing.

BACKGROUND

In recent years, various types of RFID (Radio Frequency Identification) tags, which perform noncontact exchange of information with external devices represented by a reader/writer through radio waves, have attracted attention. A type of the RFID tags has been proposed, the RFID tag being mounted with antenna patterns and IC chips for radio communication on a base sheet made of plastic or paper. Such a type of RFID tag is attached to commodities and the like and can be used for exchanging information related to the commodities with external devices to identify the commodities. A system utilizing the RFID tag is implemented or examined in every field such as agriculture, fishery, manufacturing, distribution, services, medical, welfare, public, government, traffic, and transportation.

One of the main performances of such an RFID tag is a communication limit distance equivalent to a maximum distance in which communication with an external device that transmits a radio signal with a predetermined output is possible. The communication limit distance is measured during the development or manufacture of the RFID tag. Conventionally, the communication limit distance is measured by, for example, gradually separating the RFID tag from the external device separated for a distance in which communication with the external device is possible to obtain a distance in which communication becomes impossible or by gradually approximating the RFID tag to the external device separated from the external device for a distance in which communication is impossible to thereby obtain a distance in which communication becomes possible (for example, see Japanese Laid-open Patent Publication No. 2006-322915). However, the RFID tag needs to be finely moved during the measurement in such a measurement method, which is significantly cumbersome, inhibiting efficiency of RFID tag development and manufacturing.

Thus, a technique is under consideration in which a correspondence between the distance from an external device that emits a radio signal with a predetermined output and the electric field strength of the radio signal as well as a correspondence between the size of the output by the external device and the electric field strength of the radio signal at a point separated from the external device for a predetermined distance are measured in advance, and the communication limit distance is measured by increasing and decreasing the size of the output by the external device without moving the RFID tag from a fixed position separated from the external device for a predetermined distance. To measure the communication limit distance, the size of the output by the external device is gradually decreased from the size in which the RFID tag can communicate to thereby obtain the size in which communication becomes impossible, or conversely, the size of the output by the external device is gradually increased from the size in which the RFID tag cannot communicate to thereby obtain the size in which communication becomes possible. The two kinds of correspondences measured in advance are used to convert the obtained size to the distance from the external device. The communication limit distance can be obtained through the series of processes without moving the RFID tag from the fixed position that is a predetermined distance apart from the external device.

However, the communication limit distance obtained without moving the RFID tag often does not match with the actual communication limit distance of the RFID tag in the technique. Therefore, the technique has a problem that the measurement accuracy of the communication limit distance is low.

Although the problem in the measurement of the communication limit distance has been described with the RFID tag as an example, such a problem is not limited to the RFID tag but may commonly occur in the measurement of the communication limit distance of an electronic device that receives and reacts to a radio signal.

SUMMARY

Accordingly, it is an object of the present invention to provide a testing device and a testing method capable of easily obtaining a communication limit distance of an electronic device that receives and reacts to a radio signal with high accuracy.

According to an aspect of the invention, a testing device includes a signal outputting section that has unique output characteristics and that outputs a predetermined electrical signal with electric power corresponding to a specified output level with the output characteristics when the output level is specified from multiple output levels; a specifying section that specifies the output level to the signal outputting section; a transmitting section that is supplied with the electrical signal outputted by the signal outputting section and that transmits a radio signal corresponding to the electrical signal to an electronic device that receives and reacts to the radio signal from a predetermined distance that is allowed to be a zero distance; a reaction checking section that checks the existence of the reaction in the electronic device; and a converting section that obtains an electric field strength of the radio signal received by the electronic device using the output characteristics of the signal outputting section from the output level specified by the specifying section and that converts the electric field strength to a distance between a predetermined antenna and the electronic device, the antenna transmitting the radio signal with a predetermined output and the electronic device receiving the radio signal in a same electric field strength as the electric field strength.

An object and advantages of the invention will be set forth in part in the description which follows, and in part will be obvious from the description, or may be learned by practice of the invention. The object and advantages of the invention will be realized and attained by means of the elements and combinations particularly pointed out in the appended claims.

It is to be understood that both the foregoing general description and the following detailed description are exemplary and explanatory only and are not restrictive of the invention, as claimed.

BRIEF DESCRIPTION OF DRAWINGS

FIG. 1 depicts an RFID tag testing device as a first specific embodiment of a testing device;

FIG. 2 is a functional block diagram focusing on an internal configuration of a reader/writer 200 of the RFID tag testing device 1 of FIG. 1;

FIG. 3 is a functional block diagram illustrating details of a control device 300 depicted in FIG. 1;

FIG. 4 depicts an example of an electric field strength table;

FIG. 5 depicts an operation screen for measurement process of a communication limit distance;

FIG. 6 is a flow chart illustrating a flow of a process in the measurement process of the communication limit distance executed using the operation screen for measurement process 350;

FIG. 7 depicts an RFID tag testing device as a second specific embodiment of the testing device;

FIG. 8 is a functional block diagram illustrating details of a control device 500 depicted in FIG. 7;

FIG. 9 depicts a first half of an example of the characteristic table;

FIG. 10 depicts a second half of the example of the characteristic table;

FIG. 11 is a graph of the content of the characteristic table depicted in FIGS. 9 and 10;

FIG. 12 depicts an operation screen for measurement process of a communication limit distance in the control device 500 of FIG. 8;

FIG. 13 is a graph of a relationship between the electric field strength and the distance depicted in FIGS. 9 and 10;

FIG. 14 is a flow chart illustrating a flow of a process in the measurement process of the communication limit distance executed using the operation screen for measurement process 550;

FIG. 15 is a graph of a conversion relationship between the electric field strength and the distance using a default reference electric field strength "0 (dBm)"; and

FIG. 16 depicts how a deviation is eliminated in a distance reference mode.

DESCRIPTION OF EMBODIMENTS

Specific embodiments of the testing device and the testing method described in the present invention will now be described with reference to the drawings.

A first specific embodiment of the testing device will be described first.

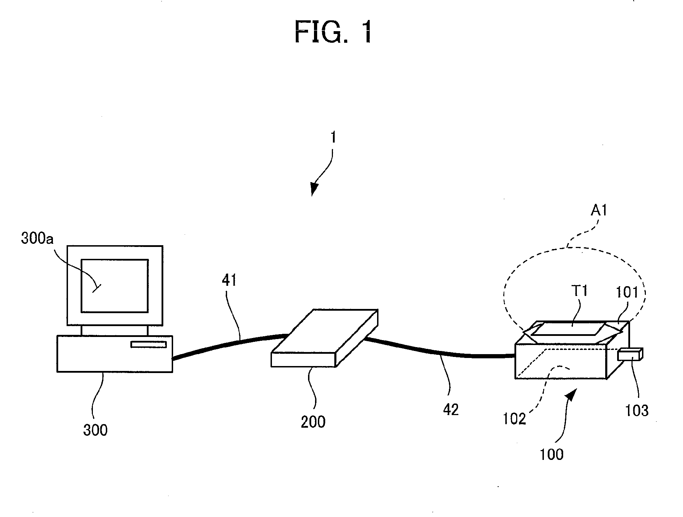

FIG. 1 depicts an RFID tag testing device as the first specific embodiment of the testing device.

After receiving a command signal as a radio signal in compliance with a predetermined communication standard, the RFID tag testing device 1 illustrated in FIG. 1 mounted with antenna patterns and IC chips for radio communication executes performance testing, such as measuring a communication limit distance described below, in relation to the communication performance of an RFID tag T1 that returns a response to the command signal as a radio signal (response signal). The RFID tag T1 handled by the RFID tag testing device 1 of the present embodiment is a so-called passive RFID tag that does not include an operational power supply and that is supplied with electric power for operation as a radio signal from outside.

The RFID tag testing device 1 includes a stripline cell 100, a reader/writer 200, and a control device 300. The reader/writer 200 is connected to the control device 300 through a first cable 41, and the stripline cell 100 is connected to the reader/writer 200 through a second cable 42. The RFID tag T1 is equivalent to an example of the electronic device of the testing device in the present invention, and the stripline cell 100 is equivalent to an example of the transmitting section as well as the stripline cell of the testing device in the present invention. The reader/writer 200 is equivalent to an example of the signal output section of the testing device in the present invention.

The communication limit distance of the RFID tag T1 denotes a maximum distance among the distances that the RFID tag T1 can respond in a situation in which a predetermined antenna used for the actual communication with the RFID tag T1 is connected to the reader/writer 200, the antenna transmits a radio signal with a predetermined output used for the actual communication, and the RFID tag T1 receives the radio signal. In the situation, the electric field strength of the radio signal received by the RFID tag T1 decreases as the RFID tag T1 moves away from the antenna and increases as the RFID tag T1 moves closer to the antenna. In the RFID tag testing device 1 of the present embodiment, the increase and decrease of the electric field strength is simulated by the increase and decrease of the output level of the reader/writer 200 as described below, and a minimum output level among the output levels that the RFID tag T1 could respond is converted to a distance between the antenna and the RFID tag T1 in the situation to thereby obtain the communication limit distance.

The stripline cell 100 includes a first conducting plate 101 with a width greater than the width of the RFID tag T1 to be tested and a second conducting plate 102 opposing the first conducting plate 101. One end of the first conducting plate 101 is connected to the second cable 42, and the reader/writer 200 supplies the command signal to the first conducting plate 101 through the one end. The other end of the first conducting plate 101 is connected to a terminating resistance 103. In the stripline cell 100, when the reader/writer 200 supplies the command signal to the first conducting plate 101, the command signal is transmitted to a predetermined propagation area A1 as a radio signal of an output corresponding to the electric power of the command signal. The RFID tag 1 to be tested is arranged in the propagation area A1 in the present embodiment. When the RFID tag T1 receives the command signal and returns a response signal, the stripline cell 100 receives the response signal. The received response signal is transmitted to the reader/writer 200 through the second cable 42.

The reader/writer 200 receives a command to the RFID tag T1 from the control device 300 and generates a command signal based on the command through encoding and modulation according to a predetermined communication standard. The reader/writer 200 is specified with an output level to the stripline cell 100 by the control device 300.

In the present embodiment, 63 output levels can be specified to the reader/writer 200 with 63 kinds of specified values from "0", corresponding to the maximum level, to "62", corresponding to the minimum level. When the control device 300 specifies an output level with one of the specified values, the reader/writer 200 generates a command signal with electric power corresponding to the specified output level. The reader/writer 200 includes unique output characteristics, and when an output level is specified, the reader/writer 200 generates a command signal with electric power corresponding to the specified output level with the output characteristics and supplies the command signal to the stripline cell 100. The output characteristics of the reader/writer 200 do not change linearly from the maximum level to the minimum level. The output characteristics are nonlinear, the output characteristics being substantially constant at the maximum level near the specified value "0" and substantially constant at the minimum level near the specified value "62".

The reader/writer 200 is selected from multiple reader/writers with different output characteristics and incorporated into the RFID tag testing device 1.

After supplying the command signal, the reader/writer 200 supplies a signal for supplying power to the RFID tag T1 to the stripline cell 100 as described below and continues to wait for a response signal from the RFID tag T1 to be transmitted from the stripline cell 100 throughout a predetermined waiting time. If the response signal is transmitted from the stripline cell 100 within the waiting time, the reader/writer 200 modulates and decodes the response signal in accordance with the communication standard to generate a response for the control device 300 and transmits the response to the control device 300 after the waiting time. If the response signal is not transmitted within the waiting time, the reader/writer 200 generates a response indicating that the RFID tag T1 does not respond to the command and transmits the response to the control device 300 after the waiting time.

The control device 300 transmits a command to the RFID tag T1 to the reader/writer 200 and transmits a level specifying signal for specifying an output level with the specified value to the reader/writer 200. The control device 300 further converts the output level (specified value) specified by the level specifying signal transmitted to the reader/writer 200 to a distance between a predetermined antenna and the RFID tag T1, the antenna used for the actual communication with the RFID tag T1 being connected to the reader/writer 200, and then displays the distance on a displaying device 300a.

In the present embodiment, the control device 300 sequentially increases or sequentially decreases the output level by a predetermined operation by a user or by internal processing of the control device 300. As described, the specified value "0" corresponds to the maximum output level and the specified value "62" corresponds to the minimum output level in the present embodiment. Therefore, an increase in the output level substantially denotes a decrease in the specified value, while a decrease in the output level substantially denotes an increase in the specified value.

The increase and decrease of the output level leads to an increase and decrease of the electric field strength of the command signal transmitted by the stripline cell 100 and received as a radio signal by the RFID tag T1. Meanwhile, in the condition in which the antenna is connected to the reader/writer 200, the antenna transmits the command signal as a radio signal with a predetermined output used for the actual communication, and the RFID tag T1 receives the command signal, moving close and away of the RFID tag T1 with respect to the antenna also leads to an increase and decrease of the electric field strength of the command signal received by the RFID tag T1. In the present embodiment, the moving close and away of the RFID tag T1 with respect to the antenna is simulated by sequentially increasing or sequentially decreasing the output levels of the reader/writer 200 and converting the output levels (specified values) to the distance, without using the antenna for the actual communication and without moving the RFID tag T1.

The control device 300 checks the existence of responses from the RFID tag T1 in relation to the increase and decrease of the output levels and further calculates the distance corresponding to each output level and displays the distance on the displaying device 300a.

The communication limit distance of the RFID tag T1 is the maximum distance among the distances that the RFID tag T1 could return the response signals in the situation described above. In the present embodiment, the moving close and away of the RFID tag T1 with respect to the antenna is simulated by the increase and decrease in the output level of the reader/writer 200. Therefore, the communication limit distance can be obtained as a conversion result from the minimum output level (maximum specified value) among the output levels that the RFID tag T1 could return the response signals. The displaying device 300a displays the distance of the conversion result as a communication limit distance of the RFID tag T1. The process for acquiring the communication limit distance will be described in detail below.

The RFID tag testing device 1 is roughly constituted as described.

The reader/writer 200 will now be described in detail.

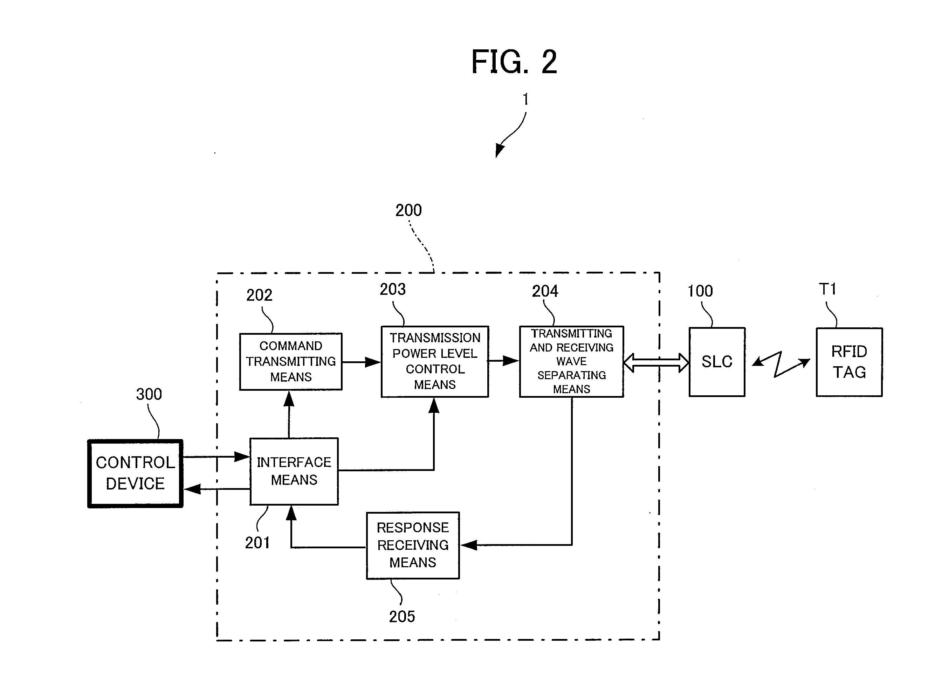

FIG. 2 is a functional block diagram focusing on an internal configuration of the reader/writer 200 of the RFID tag testing device 1 of FIG. 1.

The reader/writer 200 includes interface means 201, command transmitting means 202, transmission power level control means 203, transmitting and receiving wave separating means 204, and response receiving means 205.

When receiving a command to the RFID tag T1 from the control device 300, the interface means 201 transmits the command to the command transmitting means 202. When receiving a level specifying signal for specifying the output level of the reader/writer 200 with the specified value from the control device 300, the interface means 201 transmits the level specifying signal to the transmission power level control means 203. After transmitting the command to the command transmitting means 202, the interface means 201 continues to wait for a response to the control device 300 in relation to the command throughout a predetermined waiting time. When the response is transmitted from the response receiving means 205 within the waiting time, the interface means 201 transmits the response to the control device 300. If the response is not transmitted within the waiting time, the interface means 201 generates a response indicative of no response and transmits the response to the control device 300.

When receiving a command from the interface means 201, the command transmitting means 202 encodes the command in accordance with a communication protocol or a data format predefined by a predetermined communication standard to generate a timing signal and transmits the timing signal to the transmission power level control means 203.

When receiving a level specifying signal from the interface means 201, the transmission power level control means 203 generates a carrier signal of electric power according to the output level specified by the level specifying signal. When receiving the timing signal from the command transmitting means 202, the transmission power level control means 203 uses the timing signal to modulate the carrier signal in accordance with a predetermined modulation method to thereby generate a command signal corresponding to the command from the control device 300. The transmission power level control means 203 then transmits the generated command signal to the transmitting and receiving wave separating means 204. After transmitting the command signal, the transmission power level control means 203 continues to transmit the carrier signal used to generate the command signal to the transmitting and receiving wave separating means 204 throughout the waiting time.

When receiving a command signal from the transmission power level control means 203, the transmitting and receiving wave separating means 204 outputs the command signal to the stripline cell 100. Following the command signal, the transmitting and receiving wave separating means 204 further outputs the carrier signals transmitted throughout the waiting time to the stripline cell 100. When receiving a response signal from the RFID tag T1 from the stripline cell 100, the transmitting and receiving wave separating means 204 transmits the response signal to the response receiving means 205.

When receiving a response signal from the transmitting and receiving wave separating means 204, the response receiving means 205 demodulates and decodes the response signal in accordance with the communication standard to generate a response to the control device 300 and then transmits the response to the interface means 201.

The control device 300 will now be described in detail.

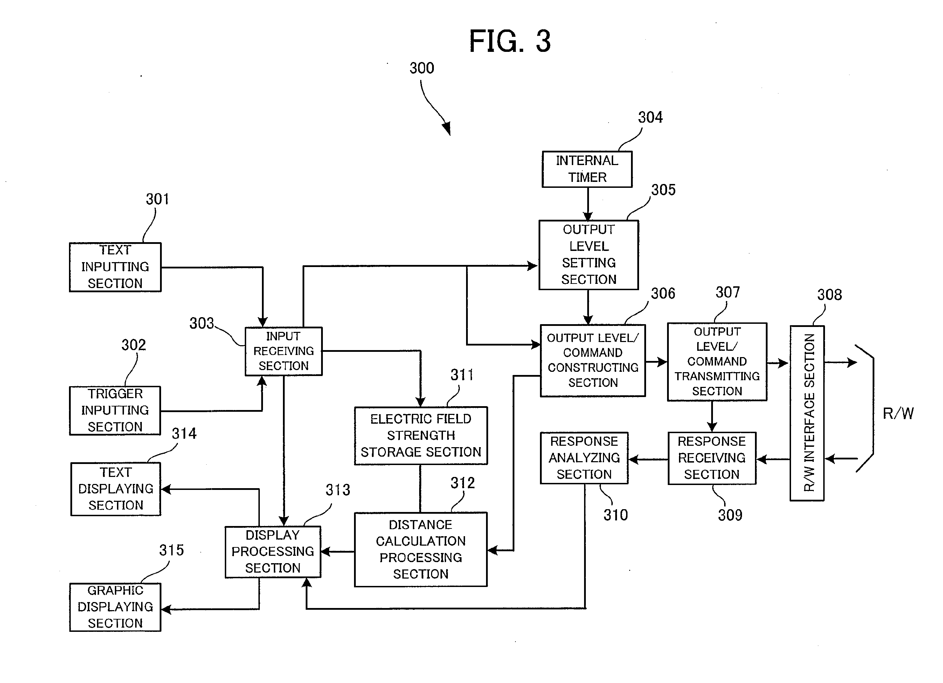

FIG. 3 is a functional block diagram depicting details of the control device 300 illustrated in FIG. 1.

The control device 300 includes a text inputting section 301, a trigger inputting section 302, and an input receiving section 303. Text information is inputted to the text inputting section 301 through a keyboard or the like. A trigger order such as an execution order of a predetermined process through a click operation of mouse or a depression operation of a predetermined key on the keyboard is inputted to the trigger inputting section 302. The input receiving section 303 receives an input to the inputting sections.

The control device 300 also includes an internal timer 304 and an output level setting section 305. The internal timer 304 informs the components in the control device 300 of every passage of predetermined time. The output level setting section 305 sets an output level of the reader/writer 200 to an output level/command constructing section 306 described below with the specified value. In the present embodiment, every time a user executes a predetermined operation and the execution is informed from the input receiving section 303, or every time the passage of time is informed from the internal timer 304, the output level setting section 305 increases or decreases the output level to be set to the output level/command constructing section 306 by "1" with the specified value. In this way, the moving close and away of the RFID tag T1 with respect to the antenna in the situation described above is simulated.

The output level/command constructing section 306 generates a level specifying signal for specifying the output level set by the output level setting section 305 with the specified value and constructs a command to the RFID tag T1. The output level/command constructing section 306 further transmits the output level transmitted from the output level setting section 305 to a distance calculation processing section 312 described below.

The control device 300 further includes an output level/command transmitting section 307 and an R/W interface section 308. The output level/command transmitting section 307 transmits a level specifying signal and a command to the reader/writer 200 through the R/W interface section 308. The output level/command transmitting section 307 also transfers a command the same as the transmitted command to a response receiving section 309 described below. The R/W interface section 308 exchanges various signals with the reader/writer 200. The command transmitted by the output level/command transmitting section 307 is transmitted to the reader/writer 200 through the R/W interface section 308, and a response to the command is transmitted to the response receiving section 309 described below through the R/W interface section 308.

The control device 300 includes the response receiving section 309 and a response analyzing section 310. The response receiving section 309 receives the response to the command from the reader/writer 200 through the R/W interface section 308. The response analyzing section 310, for example, analyzes whether the response indicates existence or nonexistence of response from the RFID tag T1. As described, a command the same as the command transmitted by the output level/command transmitting section 307 is transferred to the response receiving section 309 from the output level/command transmitting section 307. After receiving the response, the response receiving section 309 transfers a set of the received response and the command to the response analyzing section 310. During the analysis of the transferred response, the response receiving section 309 also analyzes, for example, the existence of an occurrence of a communication error. The analysis result is transmitted to a display processing section 313 described below.

A combination of the output level setting section 305, the output level/command constructing section 306, the output level/command transmitting section 307, and the R/W interface section 308 is equivalent to an example of the specifying section of the testing device in the present invention. A combination of the R/W interface section 308, the response receiving section 309, and the response analyzing section 310 is equivalent to an example of the reaction checking section in the present invention.

The control device 300 also includes an electric field strength storage section 311. The electric field strength storage section 311 stores an electric field strength table describing one-to-one correspondence between specified values from "0" to "62" denoting the 63 output levels that can be specified to the reader/writer 200 and the electric field strength of the command signal transmitted by the stripline cell 100 as a radio signal when the output levels are specified to the reader/writer 200 with the specified values. The electric field strength storage section 311 is equivalent to an example of the storage section of the testing device in the present invention.

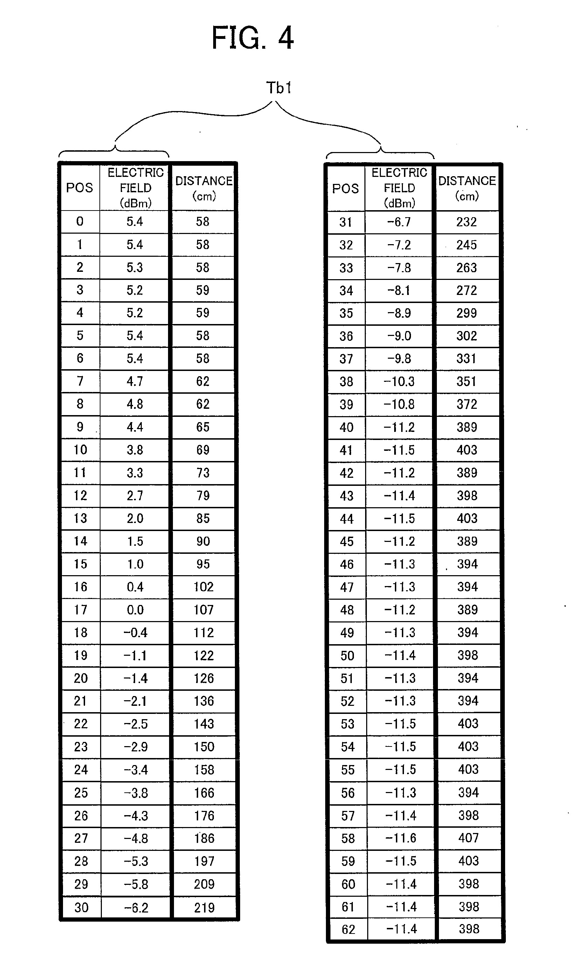

FIG. 4 depicts an example of the electric field strength table.

The electric field strength table Tb1 illustrated in FIG. 4 describes the one-to-one relationship between 63 specified values from "0" to "62" denoting the output levels and the electric field strength corresponding to the specified values and is equivalent to an example of the characteristic table of the testing device in the present invention. As described, the specified value "0" is equivalent to the maximum level and the specified value "62" is equivalent to the minimum level in the present embodiment. However, as described, the output characteristics of the reader/writer have nonlinear characteristics that are substantially constant at the maximum level near the specified value "0" and substantially constant at the minimum level near the specified value "62". Consequently, in the electric field strength table Tb1 illustrated in FIG. 4, the output characteristics are substantially constant at the maximum electric field strength "5.4 (dBm)" from about the specified value "0" to the specified value "6". Subsequently, the electric field strength is decreased in accordance with an increase in the specified value, and the output characteristics are substantially constant at "-11.4 (dBm)" as the minimum electric field strength from about the specified value "40" to the specified value "62".

FIG. 4 illustrates a conversion result adjacent to the electric field strength table Tb1, in which each electric field strength is converted to a distance between a predetermined antenna and the RFID tag T1 when the antenna for the actual communication with the RFID tag T1 is connected to the reader/writer 200. The conversion to the distance will be described in detail below.

The correspondence described in the electric field strength table Tb1 reflects the unique output characteristics included in the reader/writer 200. In the present embodiment, the electric field strength storage section 311 stores electric field strength tables reflecting unique output characteristics of each of the multiple reader/writers from which the reader/writer 200 is selected when the RFID tag testing device 1 of FIG. 1 is constructed. In the present embodiment, as illustrated in FIG. 4, the electric field strength is expressed in the electric field strength table with a unit "dBm" for simplification of the subsequent calculation. In the present embodiment, the electric field strength tables of the reader/writers are obtained from actual measurements. The measurements can be easily performed by incorporating the multiple reader/writers into the RFID tag testing device 1 of FIG. 1 and measuring the electric field strength of the command signal transmitted by the stripline cell 100 with a standard dipole antenna for each of the 63 output levels.

In the control device 300 illustrated in FIG. 3, the user specifies the reader/writer 200 included in the RFID tag testing device 1 of FIG. 1 among the multiple reader/writers whose electric field strength tables are stored in the electric field strength storage section 311 to measure the communication limit distance. Consequently, the input receiving section 303 transmits the specification result to the electric field strength storage section 311, and the electric field strength storage section 311 selects an electric field strength table corresponding to the specified reader/writer 200 among the multiple electric field strength tables and transfers the electric field strength table to the distance calculation processing section 312 described below.

The distance calculation processing section 312 illustrated in FIG. 3 converts the output level (specified value) set by the output level setting section 305 to the distance between the predetermined antenna connected to the reader/writer 200 and the RFID tag T1. The distance calculation processing section 312 is equivalent to an example of the converting section of the testing device in the present invention. The conversion from the output level to the distance by the distance calculation processing section 312 is performed by using the electric field strength table transferred from the electric field strength storage section 311 described in detail below. The distance calculation processing section 312 transfers the conversion result to the display processing section 313 described below.

The control device 300 includes a display processing section 313, a text displaying section 314, and a graphic displaying section 315. The display processing section 313 generates a screen to be displayed on the displaying device 300a illustrated in FIG. 1. The text displaying section 314 displays text information among the constituent elements of the screen on the displaying device 300a. The graphic displaying section 315 displays graphic information among the constituent elements of the screen. In the present embodiment, the distance as a conversion result, the analysis result in the response analyzing section 310, and the like are displayed on the displaying device 300a as text information or graphic information. A combination of the display processing section 313, the text displaying section 314, and the graphic displaying section 315 is equivalent to an example of the conversion result displaying section of the testing device in the present invention.

In the measurement process of the communication limit distance of the RFID tag T1 by the RFID tag testing device 1 of FIG. 1, as described, the output level setting section 305 sequentially increases or sequentially decreases the output level of the reader/writer 200 with the specified value every time the user performs a predetermined operation or every time there is a notification of the passage of time from the internal timer 304. The response analyzing section 310 then checks the existence of a response from the RFID tag T1 for each output level, and the distance calculation processing section 312 calculates the distance corresponding to each output level (specified value).

In the measurement process of the communication limit distance, the display processing section 313 displays, on the displaying device 300a, the distance calculated by the distance calculation processing section 312 with respect to the minimum output level (maximum specified value) among the output levels in which the response analyzing section 310 has checked the existence of response as a communication limit distance of the RFID tag T1 to be processed through the text displaying section 314 and the graphic displaying section 315. In this way, the communication limit distance as the maximum distance among the distances in which the RFID tag T1 to be processed could respond is displayed on the displaying device 300a. The combination of the display processing section 313, the text displaying section 314, and the graphic displaying section 315 also serves as an example of the communication limit distance displaying section of the testing device in the present invention.

The measurement process of the communication limit distance of the RFID tag T1 by the control device 300 is started when the user orders execution of the measurement process on an initial screen not illustrated and the following operation screen for measurement process is displayed on the displaying device 300a after the reception of the order.

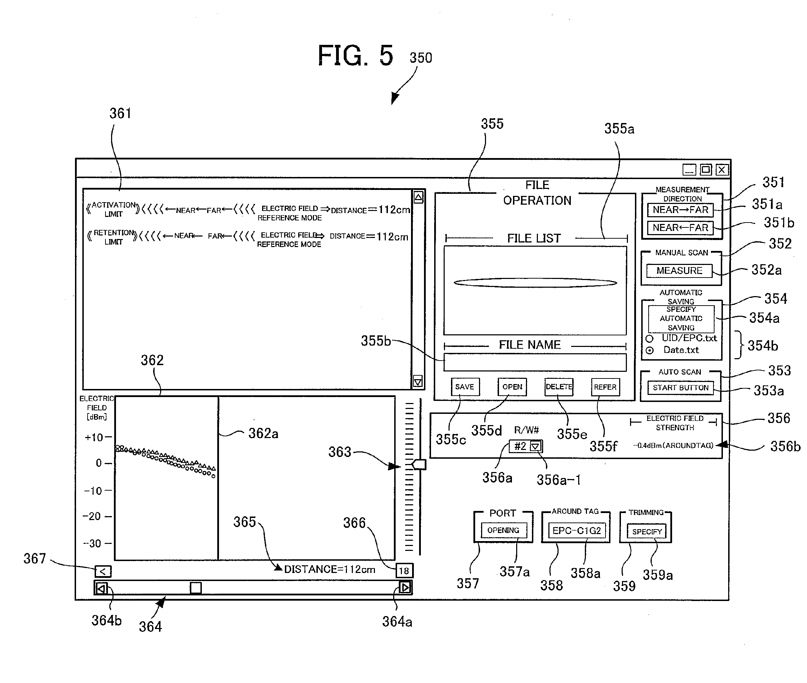

FIG. 5 depicts the operation screen for measurement process of the communication limit distance.

In the present embodiment, as described, the output level setting section 305 sequentially increases or sequentially decreases the output level (specified value) of the reader/writer 200 to simulate the approach of the RFID tag T1 to the antenna or the isolation from the antenna in the situation described above.

The operation screen for measurement process 350 illustrated in FIG. 5 includes a measurement direction specifying section 351 for a user to specify whether to execute the measurement process of the communication limit distance by simulating isolation from the antenna or by simulating approach to the antenna. The measurement direction specifying section 351 includes an isolation direction specifying button 351a for specifying an isolation direction for isolating the RFID tag T1 from the antenna and an approximation direction specifying button 351b for specifying an approximation direction for approximating the RFID tag T1 to the antenna.

In the measurement process of the communication limit distance in the present embodiment, the sequential isolation or approximation to and from the predetermined antenna, i.e. the sequential increase or decrease of the output level (specified value) of the reader/writer 200, is executed every time the user performs a predetermined operation or every time there is a notification from the internal timer 304 as described. Thus, two kinds of measurement methods are prepared in the present embodiment: a manual scan for executing the measurement process of the communication limit distance by sequentially receiving user's operations; and an auto scan for executing the measurement process by receiving notifications from the internal timer 304.

The operation screen for measurement process 350 illustrated in FIG. 5 includes a manual scanning section 352 operated by the user upon the manual scan and an auto scanning section 353 operated by the user upon the auto scan. The manual scanning section 352 includes a measurement button 352a sequentially operated by the user. In the manual scan, the output level is increased or decreased, the existence of response is checked, and the output level is converted to the distance every time the user operates the measurement button 352a in sequence. The auto scanning section 353 includes a start button 353a for the user to announce the start of a series of processes of sequentially increasing or decreasing the output level, checking the existence of responses in relation to the output levels, and converting the output levels to the distance.

In the present embodiment, the measured communication limit distance can be saved as a file describing the communication limit distance. Two saving methods are prepared in the present embodiment: automatic saving for saving with a predetermined file name; and manual saving for saving with a desired file name.

The operation screen for measurement process 350 illustrated in FIG. 5 includes an automatic saving section 354 that saves the communication limit distance by automatic saving and a manual saving section 355 that saves the communication limit distance by manual saving.

The automatic saving section 354 includes an automatic save specifying button 354a for specifying automatic saving and a file name specifying section 354b provided with a radio button for selecting a file name from "UID/EPC.txt" and "Data.txt" upon automatic saving. In the present embodiment, when the automatic save specifying button 354a is clicked at the beginning of the measurement process of the communication limit distance, the communication limit distance obtained in the subsequent measurement process is automatically described and saved in a file with the file name selected in the file name specifying section 354b. In the present embodiment, if the automatic save specifying button 354a is not clicked at the beginning of the measurement process of the communication limit distance, the communication limit distance is saved by manual saving.

The manual saving section 355 includes a file name displaying section 355a that displays a list of file names of currently saved files, a file name inputting section 355b for inputting a desired file name, a save button 355c for ordering to save with the inputted file name, a disclose button 355d for ordering to open the desired file and to display the communication limit distance described in the file, a delete button 355e for ordering to delete a desired file, and a reference button 355f for allowing to specify a file to be disclosed by a click operation of the disclose button 355d or to specify a file to be deleted by a click operation of the delete button 355e.

The manual saving of the communication limit distance is performed by the user inputting a desired file name to the file name inputting section 355b at the final stage of the measurement process and further clicking the save button 355c. The communication limit distance obtained by the measurement process is described and saved in the file with the desired file name. The user first clicks the reference button 355f to display the communication limit distance described in a desired file among currently stored files or to delete the file. As a result, the access to the file name displaying section 355a is permitted. In that condition, the user points the file name of the desired file among the file names displayed on the file name displaying section 355a with a cursor and clicks the disclose button 355d or the delete button 355e to display the communication limit distance described in the file or to delete the file.

The operation screen for measurement process 350 illustrated in FIG. 5 further includes a reader/writer specifying section 356 for the user to specify the reader/writer 200 included in the RFID tag testing device 1 among the multiple reader/writers from which the reader/writer 200 is selected when the RFID tag testing device 1 of FIG. 1 is constructed.

The reader/writer specifying section 356 includes an operating section 356a in which the user performs a specifying operation. The operating section 356a includes a menu button 356a_1. When the user clicks the menu button 356a_1, a pull-down menu describing a list of the names of the multiple reader/writers is displayed. As the user clicks the name of the reader/writer 200, the reader/writer 200 is specified and the name is displayed. The reader/writer specifying section 356 further includes a strength displaying section 356b that numerically displays the electric field strength obtained using the electric field strength table of the reader/writer 200 specified by the operating section 356a during the measurement process of the communication limit distance. As described, the output level (specified value) of the reader/writer 200 is sequentially increased or decreased during the measurement process of the communication limit distance. The strength displaying section 356b displays the electric field strength obtained by using the electric field strength table for each of the sequentially changed output levels.

The operation screen for measurement process 350 illustrated in FIG. 5 further includes a port opening section 356 that orders opening of a communication port for exchanging signals with the reader/writer 200 in the control device 300. The port opening section 357 includes an open button 357a for the user to order opening of the communication port. The user can click the open button 357a to cause the RFID tag testing device 1 to start the measurement process of the communication limit distance. The user can also click the open button 357a during the measurement process to order to retry the measurement process.

The operation screen for measurement process 350 illustrated in FIG. 5 includes a tag type inputting section 358 for inputting the type of the RFID tag to be processed. The tag type inputting section 358 includes an input field 358a for the user to input the type.

The operation screen for measurement process 350 illustrated in FIG. 5 further includes a trimming specifying section 359 that specifies the execution of trimming for sequentially increasing or decreasing the output level (specified value) of the reader/writer 200 within a predetermined range. The trimming specifying section 359 includes a trimming specifying button 359a for specifying with a click operation. The maximum specified value and the minimum specified value in the trimming range are also set to specify the execution of trimming, which will be described below. In the present embodiment, if the trimming specifying button 359a is not clicked, the maximum specified value upon the increase and decrease of the output level is the specified value "62" corresponding to the minimum output level, and the minimum specified value is the specified value "0" corresponding to the maximum output level.

The operation screen for measurement process 350 illustrated in FIG. 5 includes: a text display screen 361 that displays the communication limit distance obtained by the measurement process or various information related to the measurement process as text; and a graphic displaying section 362 that graphically displays the change in the electric field strength relative to the change in the output level (specified value) in which the electric field strength numerically displayed on the strength displaying section 356b in the reader/writer specifying section 356 is displayed longitudinally, and the output level (specified value) of the reader/writer 200 is displayed transversely. In the graphic displaying section 362, a vertical line 362a displays an output level corresponding to the communication limit distance.

The operation screen for measurement process 350 illustrated in FIG. 5 further includes an electric field strength bar 363 for displaying the electric field strength at the present moment with bar, an output level display bar 364 that displays the output level at the present moment with bar, and a distance displaying section 365 that numerically displays the distance converted from the output level.

The operation screen for measurement process 350 illustrated in FIG. 5 further includes a first setting section 366 that sets the maximum specified value in the trimming range and a second setting section 367 that sets the minimum specified value. Once the increase or decrease of the output level is started, the first setting section 366 numerically displays the specified values at each point of the increase in the output level, and the second setting section 367 numerically displays the specified value at each point of the decrease in the output level.

When setting the maximum specified value and the minimum specified value in the trimming range, after the trimming specifying button 359a is clicked, the first setting section 366 or the second setting section 367 is clicked, and the display of the setting section is changed from "<" or ">" to the numerical display. In that condition, a specified value increase button 364a or a specified value decrease button 364b of the output level display bar 364 is clicked until the numerical display in the setting sections indicate desired values. In the present embodiment, the numerical display in the setting section is increased or decreased by "1" every time the specified value increase button 364a or the specified value decrease button 364b is clicked once. If the setting section is clicked again when the numerical display in the display section becomes the desired numerical display, the maximum specified value or the minimum specified value is fixed to the value displayed on the specifying section. The maximum set value and the minimum set value are set by performing such an operation to the setting sections.

A flow of a process in the measurement process of the communication limit distance executed using the operation screen for measurement process 350 will now be described. In the description below, the constituent elements illustrated in FIGS. 3 and 5 may be referenced without reference numerals.

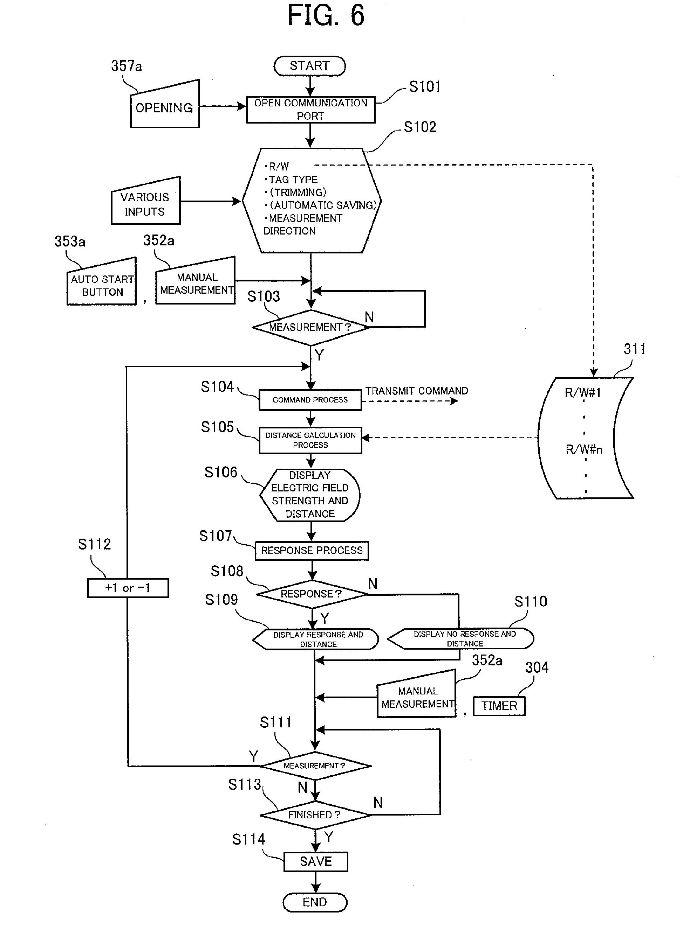

FIG. 6 is a flow chart illustrating a flow of a process of the measurement process of the communication limit distance executed using the operation screen for measurement process 350.

The process illustrated by the flow chart of FIG. 6 is equivalent to a first specific embodiment of the testing method.

As described, the process of FIG. 6 is started when the user orders execution of the measurement process on the initial screen not illustrated and the displaying device 300a displays the following operation screen for measurement process in response to the order. After the start of the process, the user first clicks the open button 357a of the port opening section 357, and the communication port for exchanging signals with the reader/writer 200 opens in the control device 300 (step S101). Consequently, the control device 300 turns to a standby state for accepting the following various input operations, and in the meantime, the user uses the operation screen for measurement process 350 to perform various input operations (step S102).

In the input operation of step S102, the user specifies the reader/writer 200 included in the RFID tag testing device 1 through the reader/writer specifying section 356, inputs the type of the RFID tag to be processed through the tag type inputting section 358, specifies the execution of trimming through the trimming specifying section 359, sets the trimming range through the output level display bar 364 and the first and second setting sections 366 and 367 in association with the specification of the execution of trimming, specifies the execution of automatic saving through the automatic saving section 354, and specifies the measurement direction through the measurement direction specifying section 351. The specifications of the execution of trimming and the automatic saving are executed if the user desires. If the user does not desire to specify the execution of trimming and does not specify the execution of trimming, the output levels are increased or decreased throughout the entire range of the specified values from "0" to "62" as described. If the user does not desire the automatic saving and does not specify the automatic saving, the saving process is executed as described with the desired file name through the manual saving section 355 at the end of the measurement process.

When the reader/writer 200 is specified in the input operation of step S102, the electric field strength storage section 311 selects an electric field strength table corresponding to the specified reader/writer 200 from the stored electric field strength tables and transfers the electric field strength table to the distance calculation processing section 312.

After the input operation of step S102, the control device 300 turns to the standby state until the user clicks the measurement button 352a of the manual scanning section 352 or clicks the start button 353a of the auto scanning section 353 (step S103). After the user performs these operations (Yes judgment in step S103), the process advances to the next process (step S104).

In step S104, the output level setting section 305 first sets the specified value at the start as the output level to the output level/command constructing section 306. The specified value at the start is determined as follows depending on whether the execution of trimming is specified in step S102 and which of the measuring directions is specified in step S102: the isolation direction for isolating the RFID tag from the predetermined antenna; or the approximation direction for approximating the RFID tag T1 to the antenna, i.e. which of the decrease and the increase of the output level is specified.

If the execution of trimming is specified, the minimum specified value set in the second setting section 367 serves as the specified value at the start when the isolation direction is specified as the measurement direction, and the maximum specified value set in the first setting section 366 serves as the specified value at the start when the approximation direction is specified as the measurement direction.

On the other hand, if the execution of trimming is not specified, "0" serves as the specified value at the start when the isolation direction is specified as the measurement direction, and "62" serves as the specified value at the start when the approximation direction is specified as the measurement direction.

Once the specified value at the start is determined, the output level/command constructing section 306 generates a level specifying signal for specifying the output level with the specified value at the start and constructs a command to the RFID tag T1 in the process of step S104. The output level/command transmitting section 307 transmits the level specifying signal and the command to the reader/writer 200. The output level/command constructing section 306 also transfers the specified value at the start set by the output level setting section 305 to the distance calculation processing section 312 in step S104. The process of step S104 is equivalent to an example of the specifying step of the testing method in the present invention.

As described, the reader/writer 200 turns to the standby state after supplying the command signal transmitted from the control device 300 to the stripline cell 100 and returns a response indicative of response or no response to the control device 300 after the waiting time. Meanwhile, the control device 300 executes the processes of steps S105 and S106 when the reader/writer 200 is in the standby state.

In step S105, the distance calculation processing section 312 first converts the specified value at the start set by the output level setting section 305 to the distance between the predetermined antenna used for the actual communication with the RFID tag T1 and the RFID tag T1, the antenna being connected to the reader/writer 200 (step S105). The process of step S105 is equivalent to an example of the converting step of the testing method in the present invention.

As described, the electric field strength storage section 311 transfers the electric field strength table corresponding to the reader/writer 200 specified in the process of step S102 to the distance calculation processing section 312. The output level/command constructing section 306 transfers the specified value at the start indicated by the level specifying signal transmitted to the reader/writer 200 in the process of step S104 to the distance calculation processing section 312.

In the process of step S105, the electric field strength corresponding to the specified value at the start in the transferred electric field strength table is first obtained.

The obtained electric field strength is then converted to the distance between the antenna and the RFID tag T1. The conversion is performed using the following conversion formula based on the correspondence between the propagation distance of radio wave and the electric field strength, the conversion formula expressing a distance "D (cm)" from the antenna as a function of an electric field strength "P (dBm)" at a point separated by the distance "D (cm)".

[Formula 1]

$$D = \left\{ d^{\left(\frac{0.6-P}{0.1}\right)} \right\} \times 100$$

$$d = 10^{\left(\frac{0.1}{20}\right)} \fallingdotseq 1.01157945425989$$

Formula (1) is a formula in which the electric field strength at the point separated by "100 (cm)" from the antenna is set to "0.6 (dBm)", and "d" is a coefficient expressing the change in the distance when the electric field strength is changed for "0.1 (dBm)". The electric field strength "0.6 (dBm)" at the point separated by "100 (cm)" from the antenna is a value obtained by measuring the electric field strength at the point separated by "100 (cm)" from the antenna in an anechoic chamber with the antenna being actually connected to the reader/writer 200.

In step S106, the electric field strength obtained from the specified value at the start in the process of step S105 is numerically displayed on the strength displaying section 356b of the reader/writer specifying section 356 and plotted on the graphic displaying section 362. The distance between the antenna and the RFID tag T1 converted from the specified value at the start is numerically displayed on the distance displaying section 365.

When the reader/writer 200 transmits the response after the waiting time after the process of steps S105 and S106 are finished, the response analyzing section 310 analyzes the response to determine, for example, the existence of the response from the RFID tag T1 and transmits the analysis result to the display processing section 313 (step S107). The process of step S107 is equivalent to an example of the reaction checking step of the testing method in the present invention.

The display processing section 313 receives the analysis result (step S108) If the analysis result indicates the existence of response (Yes judgment in step S108), the display processing section 313 displays the existence of response on the text display screen 361 (step S109). If the analysis result indicates no response (No judgment in step S108), the display processing section 313 displays the no response on the text display screen 361 (step S110).

As described below, the process from step S104 to step S112 are repeated in the process illustrated in the flow chart of FIG. 6. In step S109, the display processing section 313 compares the current analysis result of step S107 and the previous analysis result of step S107. If the results are different, the display processing section 313 numerically displays the current distance calculated in step S105 as the communication limit distance of the RFID tag T1 to be processed on the text display screen 361, and the graphic displaying section 362 displays the output level (specified value) corresponding to the communication limit distance with the vertical line 362a. In step S110, the display processing section 313 performs a similar comparison as in step S109. If the analysis results are different, the display processing section 313 numerically displays the previous distance calculated in step S105 as the communication limit distance, and the output level (specified value) corresponding to the communication limit distance is displayed with the vertical line 362a. Thus, in step S109, the distance calculated when the analysis result of the existence of response is obtained for the first time in step S107 is displayed as the communication limit distance. In step S110, the distance calculated when the analysis result of the existence of response is obtained for the last time in step S107 is displayed as the communication limit distance.

The control device 300 turns to the standby state when the display process of step S109 or step S110 is finished (step S111).

The standby state of step S111 continues until the user clicks the measurement button 352a again if the standby state of step S103 has been removed by user's click operation of the measurement button 352a of the manual scanning section 352 (Yes judgment in step S111). The standby state of step S111 continues until the internal timer 304 informs a lapse of predetermined time if the standby state of step S103 has been removed by a click operation of the start button 353a of the auto scanning section 353 (Yes judgment in step S111).

If the standby state is removed after the second click operation of the measurement button 352a or the notification from the internal timer 304, the output level setting section 305 increases or decreases the output level (specified value) by "1", and the process returns to step S104 (step S112). In step S112, if the measurement direction specified in the process of step S102 is the isolation direction, i.e. the direction in which the output level is decreased, the specified value is increased by "1". If the specified measurement direction is the approximation direction, i.e. direction in which the output level is increased, the specified value is decreased by "1".

In the process illustrated by the flow chart of FIG. 6, the process from step S104 to step S112 is repeated until a termination condition in step S113 described below is met.

As described, in step S109, the distance calculated when the analysis result of the existence of response is obtained for the first time in step S107 is displayed as the communication limit distance. In step S110, the distance calculated when the analysis result of the existence of response is obtained for the last time in step S107 is displayed as the communication limit distance. In step S112, the output level (specified value) is increased by "1" or decreased by "1" during every repetition described above. Thus, the communication limit distance displayed in step S109 or step S110 is the distance converted from the minimum output level (maximum specified value) among the output levels (specified values) in which the analysis result of the existence of response are obtained in step S107 and is the maximum distance that the RFID tag T1 to be processed can return the response.

In step S113, if the measurement direction specified in the process of step S102 is the approximation direction, i.e. the direction in which the output level is increased, and the execution of trimming is specified in step S102, the termination condition is determined to be met when the specified value that is increased or decreased by "1" in step S112 reaches the specified value set in the second setting section 367. If the measurement direction is the direction in which the output level is increased and the execution of trimming is not specified, the termination condition is determined to be met when the specified value reaches "0".

If the specified measurement direction is the isolation direction, i.e. the direction in which the output level is decreased, and the execution of trimming is specified, the termination condition is determined to be met when the specified value reaches the specified value specified in the first setting section 366. If the measurement direction is the direction in which the output level is decreased and the execution of trimming is not specified, the termination condition is determined to be met when the specified value reaches "62".

If the termination condition is determined to be met in step S113 (Yes judgment in step S113), the communication limit distance displayed in step S109 or step S110 is saved (step S114).

If the automatic saving is specified in step S102, the saving in step S114 is automatically performed by describing the communication limit distance in the file attached with the file name specified by the selection with the radio button in the file name specifying section 354b.

On the other hand, if the automatic saving is not specified in step S102, the text display screen 361 displays a message for inputting a file name to the file name inputting section 355b and for instructing saving with a click operation of the save button 355c. When the user inputs a desired file name in the file name inputting section 355b and clicks the save button 355c, the communication limit distance is described in a file with the desired file name to save the communication limit distance.

After the communication limit distance is displayed and saved in the process of step S114, the process illustrated in the flow chart of FIG. 6 is terminated.

In the present embodiment, as described, if the user clicks the open button 357a of the port opening section 357 during the process from step S102 to step S114, the execution up to then is reset, and the process is restarted from step S102.

In this way, the transmission of the command signal to the RFID tag T1 and the checking of the response are repeated based on the user's order while increasing or decreasing the output level by "1" with the specified value in the present embodiment. This is equivalent to the gradual approximation or gradual isolation of the RFID tag T1 to and from the antenna, which transmits the command signal with the predetermined output, from a sufficiently separated point, while checking the response of the RFID tag T1. The distance converted from the minimum output level (maximum specified value) serves as the communication limit distance of the RFID tag T1.

Therefore, according to the RFID tag testing device 1 of the present embodiment, the communication limit distance can be easily obtained by the manual scan with the user repeating the user's orders of step S111 while checking the existence of the distance and the response displayed on the display screen 300a without moving the RFID tag T1. In the case of the auto scan, the communication limit distance can be easily obtained even without executing such orders.

In the present embodiment, as described in the process of step S104, the output level (specified value) is converted to the distance using the electric field strength table reflecting the output characteristics of the reader/writer 200 included in the RFID tag testing device 1. Therefore, significantly accurate conversion to the distance is performed in the RFID tag testing device 1, reflecting the actual output characteristics of the reader/writer 200. As a result, the communication limit distance of the RFID tag T1 can be obtained with high accuracy. The RFID tag testing device 1 stores such electric field strength tables of multiple reader/writers other than the reader/writer 200 included in the RFID tag testing device 1. Therefore, even if another reader/writer replaces the reader/writer 200 included in the RFID tag testing device 1, the communication limit distance can be obtained with high accuracy by specifying the reader/writer after the replacement.

In the present embodiment, the electric field strength of the command signal transmitted by the stripline cell 100 is obtained using the electric field strength table based on the output level (specified value) specified by the control device 300 to the reader/writer 200, and the electric field strength is converted to the distance using the formula.

The electric field strength may be converted to the distance without using the formula as in the present embodiment by obtaining, in advance by the actual measurement, the relationship between the distance from the antenna that transmits the command signal with a predetermined output and the electric field strength and using the measurement result. In the method, the relationship between the distance from the antenna and the electric field strength is measured by, for example, measuring the electric field strength while gradually separating the electric field strength meter from the antenna in an anechoic chamber or the like. In this case, the conversion to a distance longer that the distance in which the electric field strength is measured in advance cannot be performed in the conversion using the relationship in which the distance and the electric field strength are measured.

Therefore, the distance that can be converted is limited to the dimension of the place where the measurement is performed such as the dimension of the anechoic chamber. As a result, the communication limit distance cannot be obtained if the communication limit distance included in the RFID tag to be tested exceeds the upper limit of the distance that can be converted.

However, there is no upper limit to the distance that can be converted in the RFID tag testing device 1 of the present embodiment because the electric field strength is converted to the distance using the formula. Therefore, even a significantly long communication limit distance can be obtained.

The stripline cell 100 is used to transmit the command signal as a radio signal in the RFID tag testing device 1 of the present embodiment. As described, the stripline cell 100 transmits the radio signal in a condition where the propagation range is significantly limited. Therefore, the present embodiment enables to transmit the command signal to the RFID tag T1 without using large-scale equipment such as an anechoic chamber and without electromagnetically affecting the ambient environment.

In this way, according to the RFID tag testing device 1 of the present embodiment, the communication limit distance of the RFID tag to be tested can be easily obtained with high accuracy.

A second specific embodiment of the testing device will now be described.

In the second embodiment, only a control device is different from the RFID tag testing device 1 of the first embodiment illustrated in FIG. 1. The second embodiment will now be described focusing on the difference.

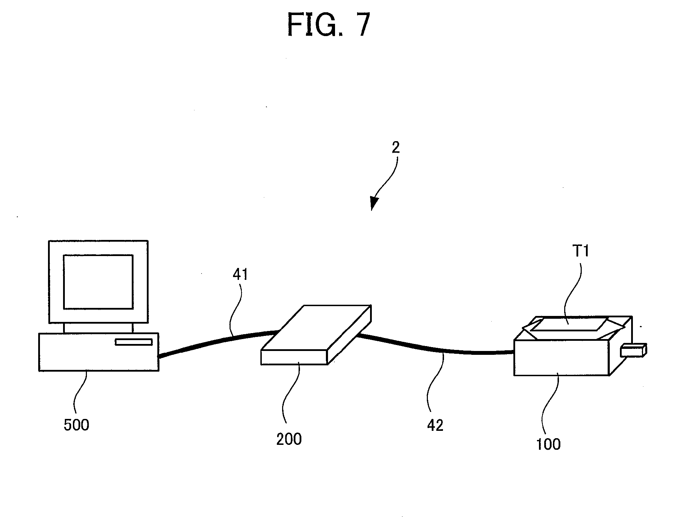

FIG. 7 depicts an RFID tag testing device as the second specific embodiment of the testing device.

In FIG. 7, constituent elements equivalent to the constituent elements of FIG. 1 are designated with the same reference numerals as in FIG. 1, and the repeated description will be omitted.

In relation to the multiple reader/writers, a control device 500 of an RFID tag testing device 2 illustrated in FIG. 7 stores, in place of the electric field strength tables, characteristic tables denoting one-to-one correspondences between multiple output levels (specified values) specified to the reader/writers and electric power of the reader/writers corresponding to each output level (specified value).

In the present embodiment, the control device 500 receives inputs of a loss factor in the second cable 42 and a damping factor in the stripline cell 100 from the user. The control device 500 obtains the electric field strength using the characteristic table corresponding to the reader/writer 200 as well as the loss factor in the second cable 42 and the damping factor in the stripline cell 100 to obtain the electric field strength of the command signal transmitted by the stripline cell 100 from the output level (specified value) specified to the reader/writer 200. A method for obtaining the electric field strength will be described in detail below.

In the present embodiment, the conversion formula for converting the electric field strength obtained as described above to the distance between the predetermined antenna, which is used for the actual communication with the RFID tag T1, and the RFID tag T1 can be modified, the antenna being connected to the reader/writer 200, the antenna transmitting the radio signal with the predetermined output used for the actual communication, and the RFID tag T1 receiving the radio signal. The modification is made using a reference electric field strength or a reference distance described below, and the user inputs the reference electric field strength and the reference distance to the control device 500 in the present embodiment. The modification of the conversion formula will also be described in detail below.

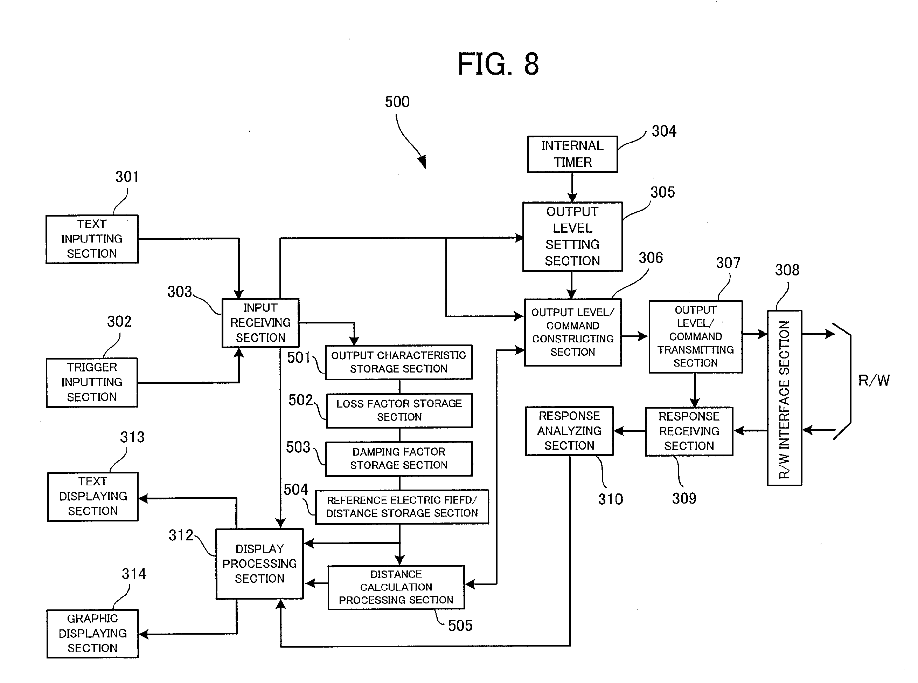

FIG. 8 is a functional block diagram illustrating the details of the control device 500 depicted in FIG. 7.

In FIG. 8, constituent elements equivalent to the constituent elements of the control device 100 of the first embodiment illustrated in FIG. 3 are designated with the same reference numerals as in FIG. 3, and the repeated description of the constituent elements will be omitted.

The control device 500 of the present embodiment includes: an output characteristic storage section 501 that stores the characteristic tables of the multiple reader/writers; a loss factor storage section 502 that stores the loss factor in the second cable 42 of FIG. 7 inputted by the user; a damping factor storage section 503 that stores the damping factor in the stripline cell 100 of FIG. 7 inputted by the user; a reference electric field/distance storage section 504 that stores the reference electric field and the reference distance described below inputted by the user; and a distance calculation processing section 505 that uses the characteristic tables, the loss factor, and the damping factor, modifies the conversion formula when the user inputs the reference electric field or the reference distance, uses the modified conversion formula to thereby perform the conversion to the distance.

A combination of the input receiving section 303 and the reference electric field/distance storage section 504 is equivalent to an example serving as the reference electric field strength inputting section and the reference distance inputting section of the testing device in the present invention. The distance calculation processing section 505 is equivalent to an example of the converting section of the testing device in the present invention.

The characteristic table will now be described.

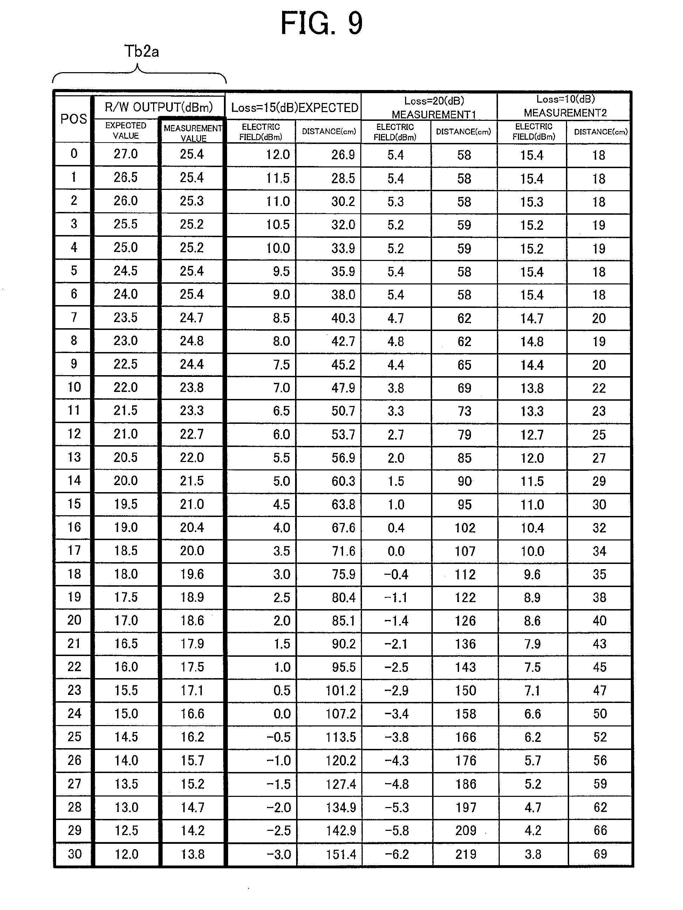

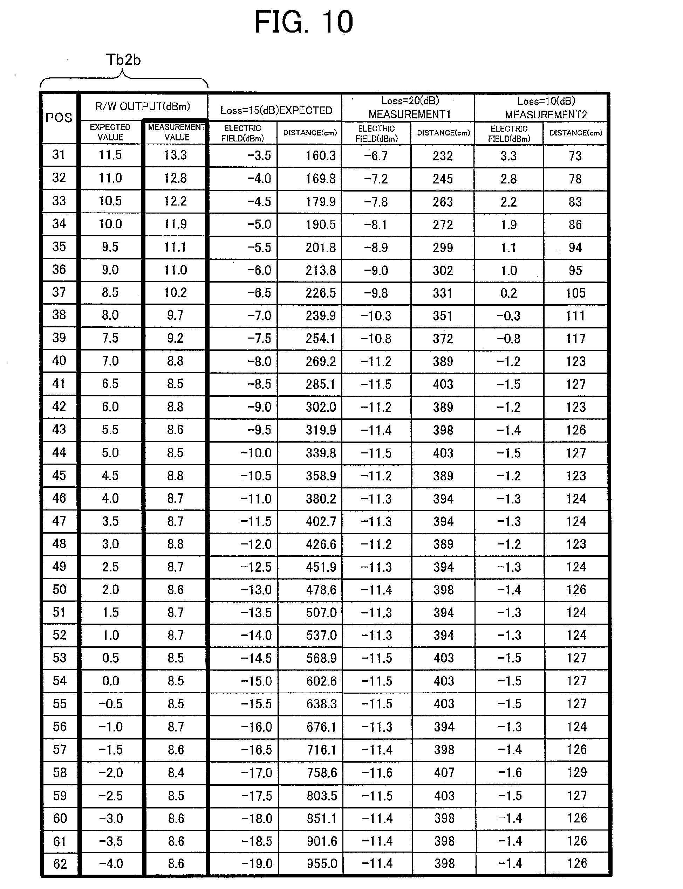

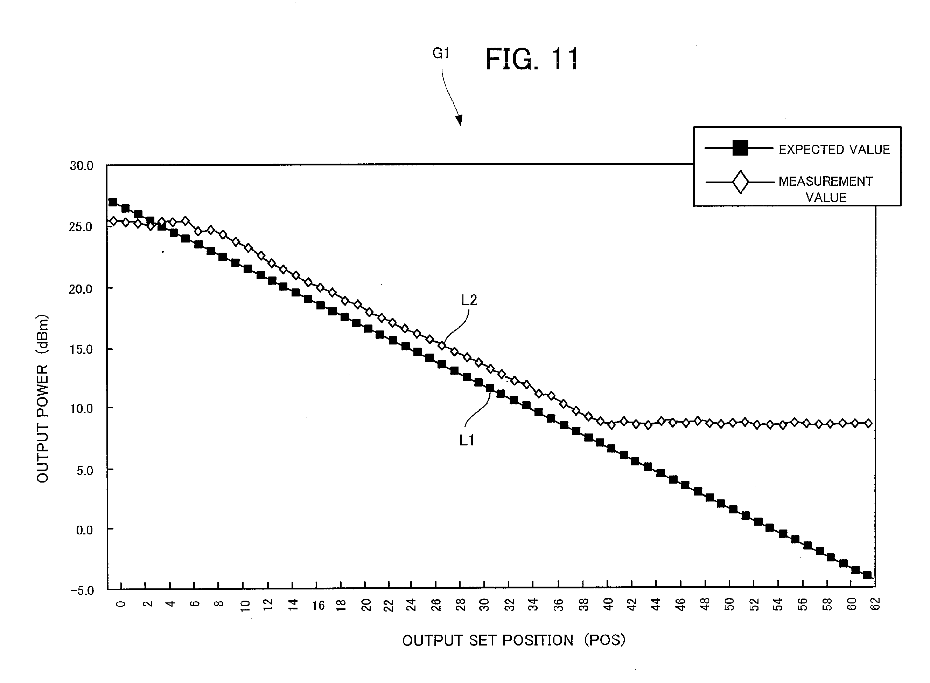

FIG. 9 depicts a first half of an example of the characteristic table. FIG. 10 depicts a second half of the example of the characteristic table. FIG. 11 is a graph of the content of the characteristic table illustrated in FIGS. 9 and 10.

A characteristic table Tb2a illustrated in FIG. 9 describes a one-to-one correspondence between the 31 specified values from "0" to "30" denoting the output levels and electric power of the reader/writers 200 corresponding to the specified values. A characteristic table Tb2b describes a one-to-one correspondence between 32 specified values from "31" to "62" and electric power. The characteristic table of a reader/writer is divided into FIGS. 9 and 10 for convenient illustration. However, the output characteristic storage section 501 of FIG. 8 stores a characteristic table describing the one-to-one correspondence between 63 specified values from "0" to "62" and electric power of a reader/writer.

The characteristic tables Tb2a and Tb2b illustrated in FIGS. 9 and 10 indicate measurement values obtained by measuring the electric power actually outputted by the reader/writer 200 according to the specified values and expected values denoting the electric power theoretically predicted from the configuration of the reader/writer 200. However, the expected values are illustrated for comparison, and the characteristic table stored in the output characteristic storage section 501 of FIG. 8 only describes the specified values and the measurement values of the electric power.

A graph G1 illustrated in FIG. 11 depicts the content of the characteristic tables Tb2a and Tb2b illustrated in FIGS. 9 and 10. Sixty three specified values from "0" to "62" are displayed transversely. The electric power of the reader/writer 200 is displayed longitudinally. The graph G1 of FIG. 11 depicts the correspondence between 63 specified values and the expected values with a line L1 connecting the black square marks and the correspondence between 63 specified values and the measurement values with a line L2 connecting the white diamond marks.

As in the first embodiment, the specified value "0" corresponds to the maximum level in the output level, and the specified value "62" corresponds to the minimum level in the characteristic tables Tb2a and Tb2b of the present embodiment illustrated in FIGS. 9 and 10. The actual output characteristics of the reader/writer 200 do not linearly change from the maximum level to the minimum level as depicted by the line L1 in the graph G1 of FIG. 11, but are nonlinear as in the first embodiment. As depicted by the line L2, the output characteristics are nonlinear, the output characteristics being substantially constant at a maximum level "25.4 (dBm)" from about specified value "0" to specified value "6", the output power decreasing as the specified value increases, and the output characteristics being substantially constant at a minimum level "8.0 (dBm)" from about specified value "40" to specified value "62".

The output characteristic storage section 501 of FIG. 8 stores characteristic tables of multiple reader/writers with different output characteristics.

FIGS. 9 and 10 depict three different cases of the total loss from the reader/writer 200 to the RFID tag T1 in relation to the electric field strength of the radio signal transmitted by the stripline cell 100 when the output levels are specified to the reader/writer 200 with the specified values (cases where the total loss is 15 (dB), 20 (dB), and 10 (dB)).

The total loss is a loss on the path from the reader/writer to the RFID tag T1 such as a sum of the loss factor in the second cable 42 and the damping factor of the stripline cell 100 in the RFID tag testing device 2 of FIG. 7. In the present embodiment, the second cable 42 in the RFID tag testing device 2 can be replaced by another cable with a different loss factor, or the stripline cell 100 can be replaced by another stripline cell with a different loss factor. Three total losses in FIGS. 9 and 10 denote losses in three cases in which the cable or the stripline cell from the reader/writer 200 to the RFID tag T1 is different.

As described, the user provides the loss factor in the cable and the damping factor in the stripline cell in the present embodiment, and the total loss is obtained as the sum of the loss factor and the damping factor. In the present embodiment, the loss factor and the damping factor are provided with a unit "dB". In this way, the electric field strength, which is expressed by a unit "dBm" of the radio signal transmitted by the stripline cell when the output levels are specified to the reader/writer 200 with the specified values, can be obtained by subtracting the total value of the loss factor and the damping factor that is provided with a unit "dB" from the electric power expressed by a unit "dBm" corresponding to the specified values in the characteristic table.

Among the electric field strengths indicating three cases in FIGS. 9 and 8, the electric field strengths in the case where the total loss is 20 (dB) and in the case where the total loss is 10 (dB) are calculated as described. For example, if the total loss is 20 (dB), the electric field strength of the radio signal transmitted by the stripline cell when the output level is specified to the reader/writer 200 with the specified value "0" is "5.4 (dBm)" in which the total loss "20 (dB)" is subtracted from the electric power (measurement value) "25.4 (dBm)" corresponding to the specified value "0".

In FIGS. 9 and 8, to compare with the two cases, the expected values of the electric field strength obtained by subtracting the total loss "15 (dB)" from the expected values of the electric power is illustrated as the electric field strength of the case where the total loss is 15 (dB).

In FIGS. 9 and 10, the distances converted from the electric field strength are illustrated for each of the three cases, and the conversion will be described below.

An operation screen for measurement process of the communication limit distance in the control device 500 of the present embodiment will now be described.

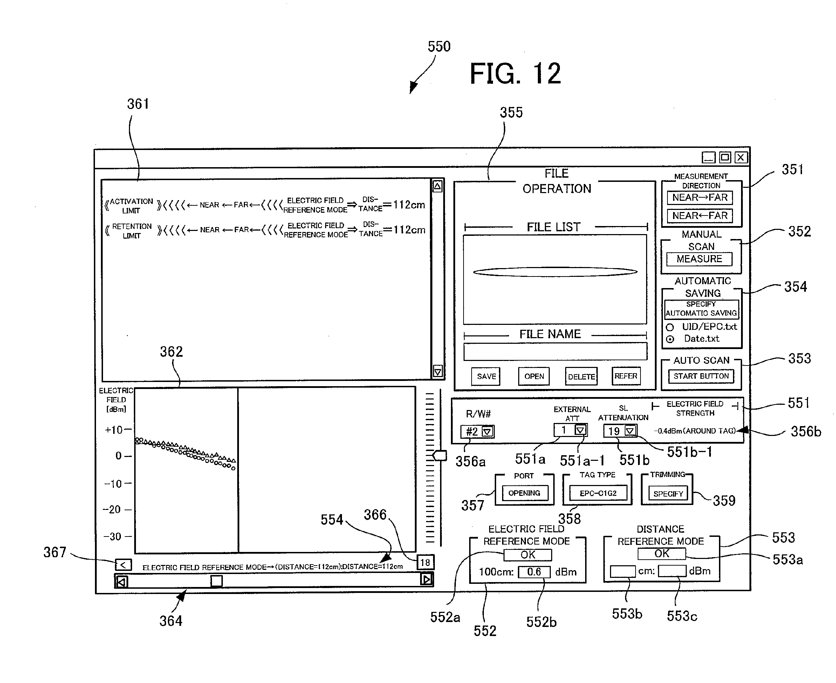

FIG. 12 depicts the operation screen for measurement process of the communication limit distance in the control device 500 of FIG. 8.

In FIG. 12, constituent elements equivalent to the constituent elements of the operation screen for measurement process 350 of the first embodiment illustrated in FIG. 5 are designated with the same reference numerals as in FIG. 5. The repeated description of the constituent elements will be omitted.

As described, in the present embodiment, the characteristic table of the reader/writer 200 of FIG. 7, the loss factor in the second cable 42, and the damping factor of the stripline cell 100 are used to obtain the electric field strength from the output level (specified value). As in the first embodiment, the characteristic table is obtained by the user specifying the reader/writer 200 of FIG. 7. Meanwhile, as described, the user numerically inputs the loss factor in the second cable 42 and the damping factor in the stripline cell 100. The operation screen for measurement process 550 of FIG. 12 includes a parameter setting section 551 in which the loss factor and the damping factor are inputted as parameters.

The parameter setting section 551 includes a loss factor inputting section 551a that is numerically inputted with the loss factor in the second cable 42 and a damping factor inputting section 551b that is numerically inputted with the damping factor in the stripline cell 100. The inputs to the two inputting sections 551a and 551b are basically performed with numerical inputs through a keyboard not illustrated. In the present embodiment, the loss factor and the damping factor numerically inputted to the inputting sections 551a and 551b are stored in the loss factor storage section 502 and the damping factor storage section 503 of FIG. 8 respectively. The loss factor and the damping factor can be easily inputted again by an operation of menu buttons 551a_1 and 551b_1 included in the inputting sections 551a and 551b. When the menu button 551a_1 or 551b_1 is clicked, a list of the loss factors stored in the loss factor storage section 502 or a list of the damping factors stored in the damping factor storage section 503 are displayed, and the user points a desired loss factor or damping factor in the lists with the cursor to input the loss factor or the damping factor.

The parameter setting section 551 further includes an operating section 356a for specifying the reader/writer 200 and a strength displaying section 356b that numerically displays the electric field strength during the measurement process of the communication limit distance, similar to the operating section 356a and the strength displaying section 356b included in the reader/writer specifying section 356 of the operation screen for measurement process 350 of the first embodiment.

In the present embodiment, the following formula is used as a conversion formula for converting the electric field strength to the distance between the predetermined antenna and the RFID tag T1 in the situation described above.

[Formula 2]

$$D = \left\{ d^{\left(\frac{Pr-P}{0.1}\right)} \right\} \times Dr$$

$$d = 10^{\left(\frac{0.1}{20}\right)} \fallingdotseq 1.01157945425989$$

In Formula 2, "D (cm)" denotes a distance between the predetermined antenna and the RFID tag T1, "d" denotes a coefficient expressing a change in the distance when the electric field strength is changed by "0.1 (dBm)", "P (dBm)" denotes an electric field strength, "Pr (dBm)" denotes a reference electric field strength described below, and "Dr (cm)" denotes a reference distance described below.

The reference electric field strength denotes an electric field strength that needs to be converted to the reference distance by Formula 2. In the present embodiment, although the reference electric field strength "0 (dBm)" is provided by default, the user can properly modify the reference electric field strength. The reference distance denotes a distance with which the reference electric field strength needs to be converted by Formula 2. In the present embodiment, although the reference distance "100 (cm)" is provided by default, the user can properly modify the reference distance. The conversion relationship expressed by the conversion formula 2, where the reference electric field strength "Pr (dBm)" is "0 (dBm)" and the reference distance "Dr (cm)" is "100 (cm)", is equivalent to an example of the initial relationship of the testing device in the present invention. The conversion relationship expressed by the conversion formula (2), where at least one of the reference electric field strength "Pr (dBm)" and the reference distance "Dr (cm)" is a modified value from the user, is equivalent to an example of the modified relationship of the testing device in the present invention.

The distance in three cases with different total losses described in FIGS. 9 and 10 is obtained by a conversion by Formula 2, where the reference electric field strength "Pr (dBm)" is a modified value "0.6 (dBm)" from the user, and the reference distance "Dr (cm)" is a default reference distance "100 (cm)".

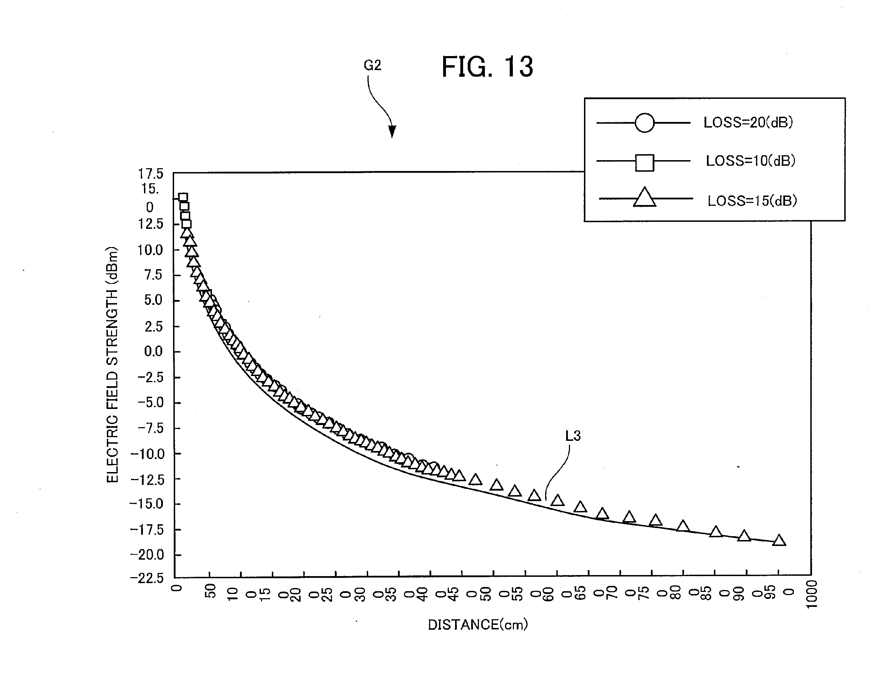

FIG. 13 is a graph of the relationship between the electric field strength and the distance illustrated in FIGS. 9 and 10.

In a graph G2 illustrated in FIG. 13, the distance is displayed transversely, and the electric field strength is displayed longitudinally. The graph G2 describes Formula 2 with a line L3, where the reference electric field strength "Pr (dBm)" is "0.6 (dBm)" and the reference distance "Dr (cm)" is "100 (cm)". On the line 3, white triangle marks plot the relationship between the expected value of the electric field strength and the distance when the total loss is 15 (dB). White circle marks plot the relationship between the electric field strength and the distance when the total loss is 20 (dB). White square marks plot the relationship between the electric field strength and the distance when the total loss is 10 (dB).

As can be seen from the line L3, Formula 2 expresses the relationship in which the electric field strength decreases by 6 (dB) if the distance is doubled, i.e. the size becomes one-fourth. Formula 2 is based on physical laws in the relationship between the electric field strength of the radio wave that emits a predetermined radio source and that propagates in the free space and the distance from the radio source.

In the present embodiment, the control device 500 includes two modes described below, an electric field reference mode and a distance reference mode, as operation modes for conversion using Formula 2.

The electric field reference mode is a mode in which the reference distance "Dr (cm)" is fixed to a default "100 (cm)", and a default "0 (dBm)" or a modified value from the user is used as the reference electric field strength "Pr (dBm)" to perform the conversion. Meanwhile, the distance reference mode is a mode in which modified values from the user are used for both of the reference electric field strength "Pr (dBm)" and the reference distance "Dr (cm)" to perform the conversion. The modified values in the two modes will be described in detail below.

The operation screen for measurement process 550 of FIG. 12 includes: an electric field reference mode setting section 552 for performing an execution order of the electric field reference mode, a modification request of the reference electric field strength "Pr (dBm)", and an input of the reference electric field strength "Pr (dBm)"; and a distance reference mode setting section 553 for performing an execution order of the distance reference mode, a modification request of the reference distance "Dr (cm)", and an input of the reference distance "Dr (cm)".

The electric field reference mode setting section 552 includes: an electric field reference mode request button 552a for ordering execution of the electric field reference mode and requesting modification of the reference electric field strength "Pr (dBm)"; and a reference electric field strength inputting section for electric field reference mode 552b for inputting the reference electric field strength "Pr (dBm)" for the electric field reference mode. An input to the reference electric field strength inputting section for electric field reference mode 552b is permitted by clicking the electric field reference mode request button 552a.

The distance reference mode setting section 553 includes: a distance reference mode request button 553a for ordering execution of the distance reference mode and requesting modification of the reference distance "Dr (cm)"; a reference distance inputting section 553b for inputting the reference distance "Dr (cm)"; and a reference electric field strength inputting section for distance reference mode 553c for inputting the reference electric field strength "Pr (dBm)" for the distance reference mode. An input to the reference distance inputting section 553b and the reference electric field strength inputting section for distance reference mode 553c is permitted by clicking the distance reference mode request button 553a.

The operation screen for measurement process 550 of FIG. 12 includes a distance displaying section 554 that displays the distance converted from the output level at the present moment displayed with bar on the output level display bar 364 as well as the operation mode at the present moment. In the present embodiment, the reference electric field strength "Pr (dBm)" can be modified, or the operation mode can be changed to the distance reference mode during the measurement process of the communication limit distance in the electric field reference mode. If the reference electric field strength "Pr (dBm)" is modified, or if the operation mode is changed to the distance reference mode, there is a high possibility that the converted distance has a different value from the distance converted under the conditions at the beginning of the measurement process. The distance displaying section 554 displays the distance converted under the conditions at the beginning in parenthesis. In an example of FIG. 12, the operation mode is the electric field reference mode, and the reference electric field strength "Pr (dBm)" is not modified during the process. Therefore, the distance converted from the output level at the present moment and the distance displayed in parenthesis correspond.

A flow of the process in the measurement process of the communication limit distance executed using the operation screen for measurement process 550 described above will now be described. In the following description, the constituent elements illustrated in FIGS. 8 and 10 may be referenced without reference numerals.

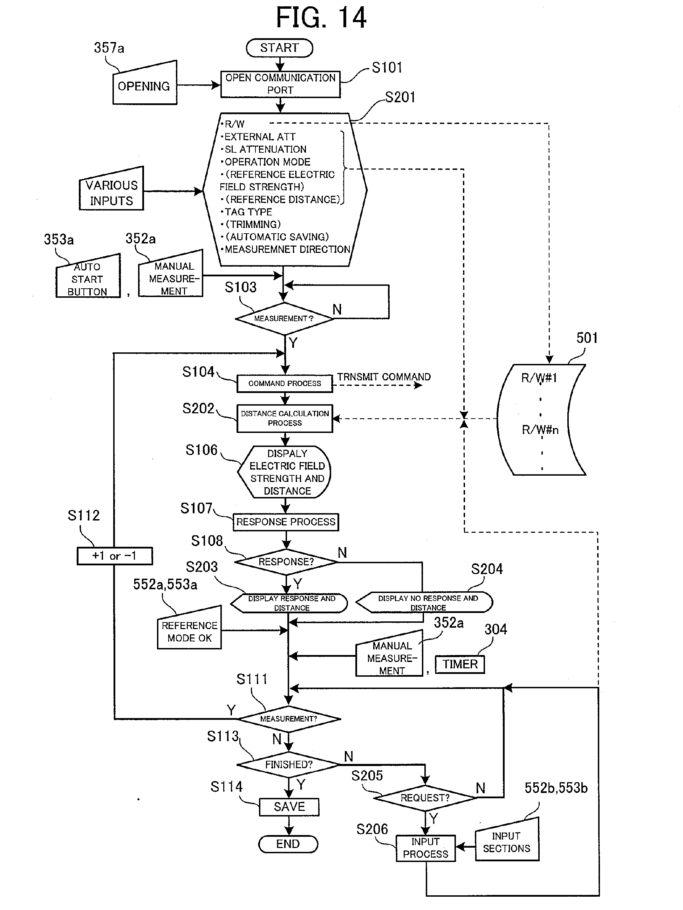

FIG. 14 is a flow chart illustrating a flow of the process in the measurement process of the communication limit distance executed using the operation screen for measurement process 550.

The process illustrated in the flow chart of FIG. 14 is equivalent to a second specific embodiment of the testing method.

In FIG. 14, processes equivalent to the processes in the flow chart of FIG. 6 are designated with the same reference numerals as in FIG. 6, and the repeated description will be omitted.

When the process illustrated by the flow chart of FIG. 14 is started, and the user clicks the open button 357a of the port opening section 357 to open the communication port in the control device 500 (step S101), the control device 500 turns to the standby state for receiving the following various input operations (step S201).

In the input operations of step S202, the reader/writer 200 included in the RFID tag testing device 2 is specified, the loss factor in the second cable 42 is inputted, the damping factor in the stripline cell 100 is inputted, the operation mode is specified, the reference electric field strength "Pr (dBm)" is inputted, the reference distance "Dr (cm)" is inputted, the type of the RFID tag to be applied is inputted, the execution of trimming is specified, the trimming range associated with the specification is set, the execution of automatic saving is specified, and the measurement direction is specified.

The execution of trimming and automatic saving are specified if the user desires. In addition, the reference electric field strength "Pr (dBm)" and the reference distance "Dr (cm)" are inputted if the user desires.

The user clicks one of the electric field reference mode request button 552a and the distance reference mode request button 553a to specify the operation mode. The electric field reference mode is specified as the operation mode if the electric field reference mode request button 552a is clicked. The distance reference mode is specified as the operation mode if the distance reference mode request button 553a is clicked.

As described, if the electric field reference mode is specified, the reference electric field strength "Pr (dBm)" can be inputted through the reference electric field strength inputting section for electric field reference mode 552b. If the distance reference mode is specified, the reference distance "Dr (cm)" can be inputted through the reference distance inputting section 553b, and the reference electric field strength "Pr (dBm)" can be inputted through the reference electric field strength inputting section for distance reference mode 553c can be inputted. If the reference electric field strength "Pr (dBm)" or the reference distance "Dr (cm)" is inputted through the inputting sections in step S202, the conversion formula in which the values are assigned to Formula 2 is used. If there is no such an input, the conversion formula in which the default reference electric field strength "0 (dBm)" and the default reference distance "100 (cm)" are assigned to Formula 2 is used.

After the input operation of step S201, the control device 300 turns to the standby state (step S103). When the user clicks the measurement button 352a of the manual scanning section 352 or the start button 353a of the auto scanning section 353 (Yes judgment in step S103), the process proceeds to the next process (step S104). In step S104, a level specifying signal for specifying the output level with the specified value at the start is generated, a command to the RFID tag T1 is constructed, and the level specifying signal and the command are transmitted.

When the process of step S104 is terminated, the distance calculation processing section 312 converts the specified value at the start set by the output level setting section 305 to the distance between the antenna and the RFID tag T1 when the predetermined antenna, which is used for the actual communication with the RFID tag T1, is connected to the reader/writer 200 (step S202). In the present embodiment, the process of step S202 is equivalent to an example of the converting step of the testing method in the present invention.

In the process of step S202, the output characteristic storage section 501 transfers the characteristic table corresponding to the reader/writer 200 specified in the process of step S201 to the distance calculation processing section 505, and the loss factor storage section 502 and the damping factor storage section 503 respectively transfer the loss factor in the second cable 42 and the damping factor in the stripline cell 100 inputted in the process of step S102 to the distance calculation processing section 505. The reference electric field/distance storage section 504 transfers the reference electric field strength "Pr (dBm)" and the reference distance "Dr (cm)" that are inputted in the process of step S201, or the default reference electric field strength "0 (dBm)" and the default reference distance "100 (cm)" to the distance calculation processing section 505. Furthermore, the output level/command constructing section 306 transfers the specified value at the start to the distance calculation processing section 505.

In the process of step S202, the electric power corresponding to the specified value at the start in the transferred characteristic table is first obtained. The total loss, which is the sum of the loss factor and the damping factor, is then subtracted from the electric power to obtain the electric field strength of the command signal transmitted by the stripline cell 100 and received by the RFID tag T1.

The obtained electric field strength is then converted to the distance between the antenna and the RFID tag T1.

The conversion is performed using Formula 2, and if the electric field reference mode is specified as the operation mode in step S201, the reference distance "Dr (cm)" in Formula 2 is fixed to the default reference distance "100 (cm)". If the reference electric field strength "Pr (dBm)" for the electric field reference mode is inputted in step S201, the input value is assigned to the reference electric field strength "Pr (dBm)" in Formula 2. If there is no input, the default reference electric field strength "0 (dBm)" is assigned.

In the case the distance reference mode is specified as the operation mode in step S201, if the reference electric field strength "Pr (dBm)" and the reference distance "Dr (cm)" for the distance reference mode are inputted in step S201, the input values are assigned to the reference electric field strength "Pr (dBm)" and the reference distance "Dr (cm)" in Formula 2. If there is no input, the default reference electric field strength "0 (dBm)" and the default reference distance "100 (cm)" are assigned.

When the conversion formula is fixed through such assignments, the fixed conversion formula is used to convert the electric field strength to the distance.

When the conversion in step S202 is terminated, the electric field strength obtained from the specified value at the start is numerically displayed on the strength displaying section 356b of the parameter setting section 551 and plotted on the graphic displaying section 362.

The distance displaying section 554 then numerically displays the distance between the antenna and the RFID tag T1 converted from the specified value at the start. In the present embodiment, the distance displaying section 554 also displays the converted distance in parenthesis.

After the termination of the processes of step S202 and step S106, the response transmitted by the reader/writer 200 is analyzed to determine, for example, the existence of the response from the RFID tag T1, and the analysis result is transmitted to the display processing section 313 (step S107).

The display processing section 313 receives the analysis result (step S108). If the analysis result indicates the existence of response (Yes judgment in step S108), the display processing section 313 displays the existence of response on the text display screen 361 (step S203). If the analysis result indicates no response (No judgment in step S108), the display processing section 313 displays the no response on the text display screen 361 (step S204).

As described below, in the process illustrated by the flow chart of FIG. 14, the process from step S104 to step S112 is repeated. In step S204, the display processing section 313 compares the analysis result in the current step S107 and the analysis result in the previous step S107. If the analysis results are different, the display processing section 313 numerically displays the distance calculated in the current step S202 on the text display screen 361 as the communication limit distance of the RFID tag T1 to be processed, and the graphic displaying section 362 displays the output level (specified value) corresponding to the communication limit distance with the vertical line 362a. In step S204, the display processing section 313 performs a similar comparison as in step S109, and if the results are different, the display processing section 313 numerically displays the distance calculated in the previous step S202 as the communication limit distance and displays the output level (specified value) corresponding to the communication limit distance with the vertical line 362a.

The control device 500 turns to the standby state when the display process of step S203 or step S204 is terminated (step S111).

The standby state of step S111 continues until the user again clicks the measurement button 352a (Yes judgment in step S111) if the user has clicked the measurement button 352a of the manual scanning section 352 to remove the standby state of step S103. The standby state of step S111 continues until the internal timer 304 informs a lapse of predetermined time (Yes judgment in step S111) if the standby state of step S103 has been removed by a click operation of the start button 353a of the auto scanning section 353.

In the present embodiment, during the standby state of step S111, the user can click the electric field reference mode request button 552a or the distance reference mode request button 553a to, for example, request a change in the operation mode.

If the standby state is removed by the second click operation of the measurement button 352a or by the notification from the internal timer 304, the output level setting section 305 increases or decreases the output level (specified value) by "1", and the process returns to step S104 (step S112).

In the process illustrated by the flow chart of FIG. 14, the process from step S104 to step S112 is repeated until the termination condition in step S113 described below is met.

In step S113, whether the specified value increased or decreased by "1" in step S112 reaches a specified value of the end determined by the existence of the specification of trimming and the specified measurement direction is judged. If the specified value reaches the specified value of the end (Yes judgment in step S113), the repetition is halted, and the process proceeds to the next process (step S114).

On the other hand, if the specified value increased or decreased by "1" in step S112 does not reach the specified value of the end (No judgment in step S113), the process of steps S205 and S206 described below is executed, and the process from step S104 to step S112 is repeated.

In step S205, whether the user has, for example, requested a change in the operation mode during the standby state of step S111 is determined.

If the user has not made a request (No judgment in step S205), the process returns to the standby state of step S111. On the other hand, if the user has made a request (Yes judgment in step S205), an input process corresponding to the requests by the user is executed (step S206), and then the process returns to the standby state of step S111.

If there is, for example, a request change of the operation mode, the subsequent conversion in step S202 is executed in the operation mode after the change using the reference electric field strength "Pr (dBm)" or the reference distance "Dr (cm)" inputted in step S206. In the present embodiment, the conversion before the change in the operation mode is also executed again when the operation mode is changed. If the communication limit distance has been displayed in the process of step S203 or step S204 before the change, the display is changed to the value based on the conversion executed again.

In step S114, the communication limit distance is saved automatically or manually through the manual saving section 355 based on the specification in step S201. When the display and the save of the communication limit distance in the process of step S114 are completed, the process illustrated by the flow chart of FIG. 14 is terminated.

In the process illustrated by the flow chart of FIG. 14, the electric field strength for conversion converted to the distance in step S202 can be obtained from the characteristic table of the reader/writer 200, the loss factor of the second cable 42, and the damping factor of the stripline cell 100, as described above.

In the present embodiment, the characteristic table, the loss factor, and the damping factor are based on the actual measurement. In the present embodiment, as for the characteristic table of the reader/writer 200, the output characteristic storage section 501 stores a characteristic table actually measured in relation to the reader/writer 200, and the characteristic table is used to obtain the electric field strength. On the other hand, the user inputs known values to the loss factor of the second cable 42 and the damping factor of the stripline cell 100. Although it is presumed that measurement values are inputted as the values, there is a possibility that the values inputted by the user are not the measurement values of the second cable 42 and the stripline cell 100 of the RFID tag testing device 2. For example, the values may be obtained from a cable and a stripline cell that are the same types as the second cable S42 and the stripline cell 100 but that are different. In such a case, there may be a deviation between the electric field strength for conversion that is obtained from the characteristic table, loss factor, and the damping factor and that is displayed on the strength displaying section 356b and the electric field strength of the radio signal actually transmitted by the stripline cell 100. If there is a deviation between the electric field strengths, the accuracy of the distance obtained by the conversion from the electric field strength, moreover, the accuracy of the communication limit distance obtained in the RFID tag testing device 2 is decreased.

The decrease in the accuracy of the communication limit distance will be described with specific examples.

For example, it is assumed that the communication limit distance of the RFID tag T1 with the actual communication limit distance "110 (cm)" is measured through the series of processes. In this case, the electric field strength of the radio signal received by the RFID tag T1 with the communication limit distance "110 (cm)" is assumed to be "-1.0 (dBm)" in the actual usage.

It is also assumed that the user has specified the electric field reference mode as the operation mode in step S201 of FIG. 14 and has not specifically inputted the reference electric field strength "Pr (dBm)". As a result, the default reference electric field strength "0 (dBm)" is assigned to Formula 2 in the conversion of step S202.

It is further assumed that the electric field strength of the radio signal that the stripline cell 100 actually transmits when the electric field strength for conversion is "0 (dBm)" is "-1.0 (dBm)" in the RFID tag testing device 2 of FIG. 7.

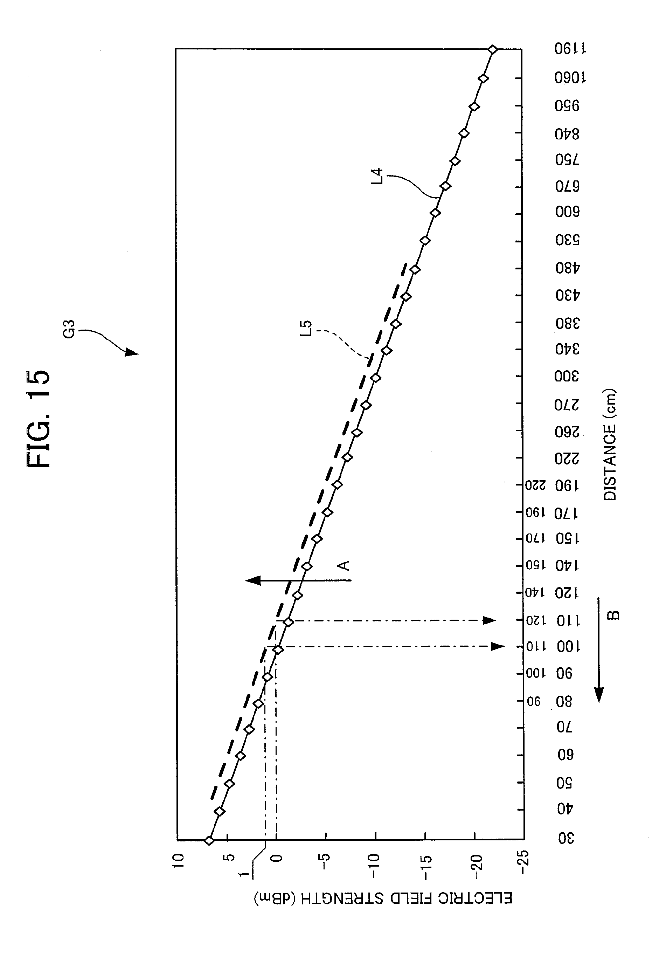

FIG. 15 is a graph of a conversion relationship between the electric field strength and the distance using the default reference electric field strength "0 (dBm)".

In a graph G3 of FIG. 15, a line L4 connecting white diamond marks illustrates the conversion relationship of Formula 2 using the default reference electric field strength "0 (dBm)". The graph G3 is a logarithmic graph displaying the distance transversely in the logarithmic scale.

In the conversion relationship illustrated by the line L4, the distance "100 (cm)" can be obtained when the electric field strength for conversion is "0 (dBm)". However, with the assumptions described above, the actual electric field strength is "-1.0 (dBm)" that is the electric field strength of the radio signal received by the RFID tag T1 when the communication limit distance is "110 (cm)". Therefore, the communication limit distance obtained by the RFID tag testing device 2 is "100 (cm)" which is different from the actual communication limit distance "110 (cm)".

In the present embodiment, such a deviation in the electric field strength can be eliminated by inputting an appropriate reference electric field strength "Pr (dBm)" or reference distance "Dr (cm)" in step S201.

A method of eliminating the deviation by inputting the appropriate reference electric field strength "Pr (dBm)" will be described first.

The method is performed in the electric field reference mode.

As described, the deviation between the electric field strength for conversion and the actual electric field strength is caused by the inaccuracy in the loss factor of the second cable 42 and the damping factor of the stripline cell 100 inputted by the user. The loss factor and the damping factor are fixed to obtain the electric field strength for conversion. The deviation occurs to every electric field strength for conversion in the same way.

The electric field strength for conversion "P (dBm)" is subtracted from the reference electric field strength "Pr (dBm)" in Formula 2. The deviation is the same for every electric field strength for conversion "P (dBm)". Therefore, the electric field strength for conversion "P (dBm)" can be corrected to the actual electric field strength by inputting a value of the reference electric field strength "Pr (dBm)" such as to eliminate the value of deviation before conversion.

A specific value of deviation needs to be known to input the appropriate reference electric field strength "Pr (dBm)" for eliminating the value of deviation. However, in reality, the user often does not figure out the value of deviation when measuring the communication limit distance. In the present embodiment, a specific value of deviation can be obtained by the following procedure.

A standard dipole antenna for measuring the electric field strength is mounted on the stripline cell 100 in place of the RFID tag T1. The electric field reference mode is specified as the operation mode. The reference electric field strength "Pr (dBm)" is not particularly inputted, but instead, the default reference electric field strength "0 (dBm)" is used. The process is advanced by auto scan or manual scan until the display of the distance in the distance displaying section 554 becomes "100 (cm)". The actual electric field strength of the radio signal transmitted by the stripline cell 100 is measured by the standard dipole antenna when the display becomes "100 (cm)".

With the series of processes, the actual electric field strength is measured when the conversion to the default reference distance "100 (cm)" is performed. The electric field strength for conversion "P (dBm)" corresponding to the measured actual electric field strength is the default reference electric field strength "0 (dBm)". The specific value of deviation can be obtained by calculating the difference between the actual electric field strength and the default reference electric field strength "0 (dBm)".

The appropriate reference electric field strength "Pr (dBm)" for eliminating the value of deviation can be obtained by adding the obtained value of deviation to the default reference electric field strength "0 (dBm)".

For example, with the assumptions described above, the actual electric field strength when the conversion to the default reference distance "100 (cm)" is performed is "-1.0 (dBm)". Therefore, the value of deviation is "1.0 (dBm)", which is the difference between the two. The value of deviation "1.0 (dBm)" is added to the default reference electric field strength "0 (dBm)", and the appropriate reference electric field strength "1.0 (dBm)" is obtained.

The appropriate reference electric field strength "Pr (dBm)" obtained this way is inputted in step S201 of FIG. 14 to properly eliminate the value of deviation "1.0 (dBm)" during the conversion to the distance.

In the graph G3 of FIG. 15, the line L4 connecting the white diamond marks illustrates a conversion relationship (conversion relationship at the beginning) of Formula 2 using the default reference electric strength "0 (dBm)" and the default reference distance "100 (cm)". A line L5 formed by dashed line illustrates a conversion relationship (modified conversion relationship) of Formula 2 using the appropriate reference electric field strength "1.0 (dBm)". As can be seen by comparing the two lines, the modified conversion relationship is equivalent to the conversion relationship at the beginning moved in parallel in an arrow A direction by the value of deviation ("1.0 (dBm)" in the example here). This is also equivalent to rereading the distance obtained from the conversion relationship at the beginning after shifting the transverse scale of the graph G3 in a direction illustrated by an arrow B.

In this way, the deviation between the electric field strength for conversion and the actual electric field strength is eliminated with calculation in the measurement process of the communication limit distance executed by inputting the appropriate reference electric field strength "Pr (dBm)" in step S201 of FIG. 14.

With the assumptions described above, the actual communication limit distance is "110 (cm)", and the electric field strength of the radio signal received by the RFID tag T1 with the communication limit distance "110 (cm)" is "-1.0 (dBm)". The actual electric field strength when the electric field strength for conversion is "0 (dBm)" is "-1.0 (dBm)". In the present embodiment, the electric field strength "0 (dBm)" that is converted to "100 (cm)" with the conversion relationship at the beginning is converted to "110 (cm)" by the modified conversion relationship. In this way, the communication limit distance can be obtained correctly as "110 (cm)", which has been wrongly obtained as "100 (cm)" in the measurement process using the conversion relationship at the beginning.

As described, in the method of eliminating the deviation by inputting the appropriate reference electric field strength "Pr (dBm)", the user measures a specific value of deviation through the series of processes to obtain the appropriate reference electric field strength "Pr (dBm)" for eliminating the value of deviation prior to the measurement process of the communication limit distance of the RFID tag T1. Upon the measurement process of the communication limit distance of the RFID tag T1, the user can obtain an accurate communication limit distance by specifying the electric field reference mode as the operation mode and inputting the appropriate reference electric field strength "Pr (dBm)".

A method of eliminating the deviation by inputting the appropriate reference distance "Dr (cm)" and the appropriate reference electric field strength "Pr (dBm)" will now be described.

The method is performed in the distance reference mode.

In the distance reference mode, the user inputs the reference distance "Dr (cm)" and the reference electric field strength "Pr (dBm)" that needs to be converted to the reference distance "Dr (cm)" in step S201 of FIG. 14. If appropriate values are inputted in which it is definitely known that the reference distance "Dr (cm)" and the reference electric field strength "Pr (dBm)" correspond, a highly accurate conversion in which the deviation is eliminated can be performed, even if the electric field strength for conversion and the actual electric field strength are deviated.

In the present embodiment, the appropriate reference distance "Dr (cm)" and the appropriate reference electric field strength "Pr (dBm)" that are definitely known to correspond are obtained by the following process prior to the measurement of the actual communication limit distance.

A standard RFID tag T1 is first prepared in which the communication limit distance is already known, and the measurement process of the communication limit distance of the standard RFID tag T1 is executed. In step S201 of FIG. 14, the distance reference mode is specified as the operation mode, the reference distance "Dr (cm)" and the reference electric field strength "Pr (dBm)" are not inputted, and the default values are used in the process. The electric field strength for conversion displayed on the strength displaying section 356b when the communication limit distance is displayed on the text display screen 361 in the process is recorded. The recorded electric field strength for conversion is the minimum electric field strength that the standard RFID tag T1 can react and is an electric field strength that needs to be converted to the actual communication limit distance that is already known. Thus, it can be said that the actual communication limit distance that is already known and the electric field strength for conversion are the distance and the electric field strength that definitely correspond.

In the present embodiment, such a distance and an electric field strength obtained by the process using the standard RFID tag T1 are used as the appropriate reference distance "Dr (cm)" and the appropriate reference electric field strength "Pr (dBm)".

The elimination of the deviation in the distance reference mode will be further described in detail with a specific example.

It is assumed that the actual communication limit distance of the standard RFID tag T1 is "140 (cm)" and the electric field strength for conversion that is obtained in the process and that definitely corresponds to the communication limit distance "140 (cm)" is "-5.0 (dBm) ".

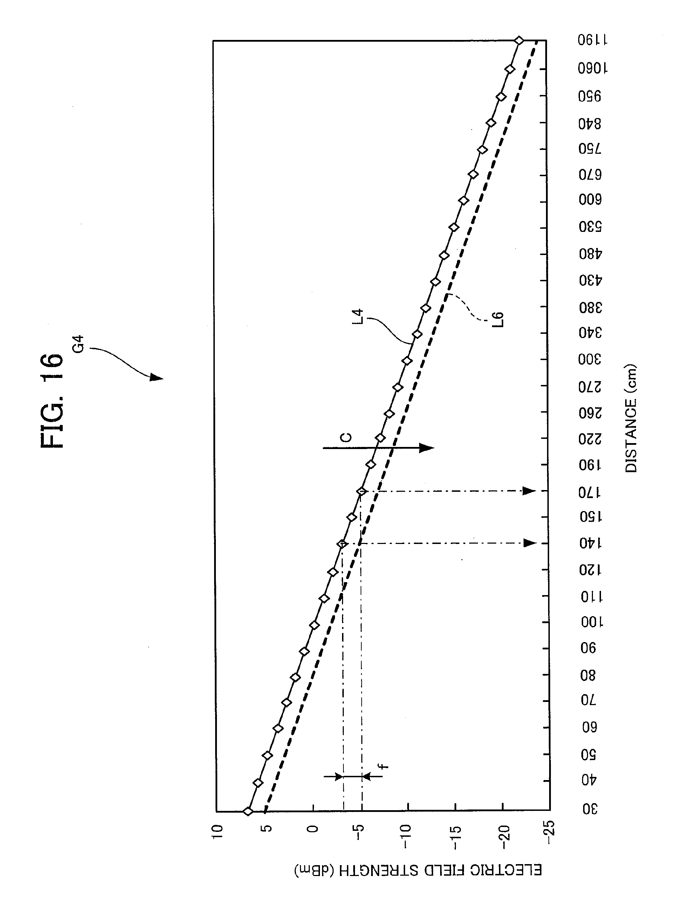

FIG. 16 depicts how the deviation is eliminated in the distance reference mode.

As in the graph G3 illustrated in FIG. 15, a graph G4 illustrated in FIG. 16 is a logarithmic graph in which the distance is displayed transversely in the logarithmic scale. As in FIG. 15, the graph G4 depicts, with the line L4 connecting the white diamond marks, a conversion relationship expressed by the conversion formula before modification in which the reference electric field strength "Pr (dBm)" is "0 (dBm)" and the reference distance "Dr (cm)" is "100 (cm)".

As can be seen from the line L4, the communication limit distance displayed on the text display screen 361 when the electric field strength for conversion is "-5.0 (dBm)" is "170 (cm)", which is "30 (cm)" longer than the communication limit distance "140 (cm)" that is already known. The user records the electric field strength for conversion "-5.0 (dBm)" displayed on the strength displaying section 356b when the communication limit distance "170 (cm)" is displayed.

In the measurement process of the actual communication limit distance, the distance reference mode is specified as the operation mode, the communication limit distance "140 (cm)" of the standard RFID tag T1 is inputted as the appropriate reference distance "Dr (cm)", and the electric field strength for conversion "-5.0 (dBm)" recorded in the process is inputted as the appropriate reference electric field strength "Pr (dBm)" in step S201 of FIG. 14.

The graph G4 of FIG. 16 depicts a conversion relationship (modified conversion relationship) expressed by Formula 2 assigned with the appropriate values with a line L6 formed by dashed line. In the conversion relationship illustrated by the line L6 formed by dashed line, the electric field strength for conversion "-5.0 (dBm)" is converted to the distance "140 (cm)" as described. The modified conversion relationship illustrated by the line L6 formed by dashed line is equivalent to the one in which the conversion relationship (conversion relationship before modification) illustrated by the line L4 is moved in parallel in an arrow C direction for a value f of deviation of the electric field strength at the distance "140 (cm)". In this way, by using the distance and the electric field strength that are definitely known to correspond as the reference distance and the reference electric field strength, a highly accurate conversion in which the deviation is eliminated can be performed, even if the electric field strength for conversion and the actual electric field strength are deviated.

As described, in the present embodiment, the deviation between the electric field strength for conversion and the actual electric field strength can be eliminated by using the appropriate reference electric field strength in the electric field reference mode, and the deviation can be eliminated by using the appropriate reference distance and the appropriate reference electric field strength in the distance reference mode.

In the present embodiment, a change in the operation mode can be requested in the waiting time of step S111 of FIG. 14. If the operation mode is changed after the communication limit distance is displayed, the communication limit distance is changed to a value based on the conversion in the operation mode after the change. As a result, when, for example, the communication limit distance is obtained in the electric field reference mode based on the appropriate reference electric field strength, the accuracy of the communication limit distance can be checked by measurement by changing the operation mode to the distance reference mode, causing the communication limit distance in the distance reference mode to be displayed based on the appropriate reference distance and the appropriate reference electric field strength, and comparing the communication limit distances in two operation modes.

As described, according to the RFID tag testing device 2 of the present embodiment, the communication limit distance of the RFID tag T1 can be easily obtained with high accuracy as in the RFID tag testing device 1 of the first embodiment. Furthermore, the communication limit distance can be obtained with higher accuracy by using the appropriate reference electric field strength in the electric field reference mode or using the appropriate reference distance and the appropriate reference electric field strength in the distance reference mode.

Although the stripline cell 100 has been illustrated as an example of the transmitting section of the testing device in the present invention, the transmitting section is not limited to this. The transmitting section may be, for example, an antenna used for the actual communication with the RFID tag. In that case, the electric field strength table as an example of the characteristic table of the testing device in the present invention describes, for example, a one-to-one correspondence between the multiple specific values of the output levels with respective to the reader/writer and the electric field strengths corresponding to the specified values at a point that is "1 (m)" away from the antenna. When using the antenna as the transmitting section, for example, the characteristic table described with the output characteristics of the reader/writer may be used as in the second embodiment, and the user may numerically input the antenna gain of the antenna or the spatial damping factor at the point that is "1(m)" away from the antenna.

According to the present invention, the electric field strength of the radio signal received by the electronic device from the output level specified by the specifying section can be obtained, and the electric field strength is further converted to the distance between the antenna and the electronic device. Therefore, the communication limit distance of the electronic device can be obtained by a simple operation such as gradually raising the output level while the reaction checking section checking the existence of the reaction without moving the electronic device. The accuracy of the communication limit distance obtained by the operation depends on the accuracy of obtaining the electric field strength from the output level and the accuracy of converting from the electric field strength to the distance. The conversion from the electric field strength to the distance can be accurately performed in accordance with, for example, general physical laws denoting the correspondence between the propagation distance of radio wave and the electric field strength. Therefore, the accuracy of the communication limit distance largely depends on how accurately the electric field strength of the radio signal received by the electronic device from the output level specified by the specifying section can be obtained. According to the present invention, the electric field strength can be obtained based on the unique output characteristics included in the signal outputting section. Thus, significantly accurate electric field strength can be obtained, and as a result, the converting section can obtain a highly accurate communication limit distance.

Therefore, according to the testing device and the testing method in the present invention, the communication limit distance of the electronic device that receives and reacts to the radio signal can be easily obtained with high accuracy.

All examples and conditional language recited herein are intended for pedagogical purposes to aid the reader in understanding the principles of the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiment of the present invention have been described in detail, it should be understood that the various changes, substitutions, and alterations could be made hereto without departing from the spirit and scope of the invention.

**Claims**

1. A testing device (1) comprising:

   a signal outputting section (200) that has unique output characteristics and that outputs a predetermined electrical signal with electric power corresponding to a specified output level with the output characteristics when the output level is specified from a plurality of output levels;
   a specifying section (305, 306, 307, 308) that specifies the output level to the signal outputting section;
   a transmitting section (100) that is supplied with the electrical signal outputted by the signal outputting section and that transmits a radio signal corresponding to the electrical signal to an electronic device that receives and reacts to the radio signal from a predetermined distance that is allowed to be a zero distance;
   a reaction checking section (308, 309, 310) that checks the existence of the reaction in the electronic device; and
   a converting section (313, 314, 315) that obtains an electric field strength of the radio signal received by the electronic device using the output characteristics of the signal outputting section from the output level specified by the specifying section and that converts the electric field strength to a distance between a predetermined antenna and the electronic device, the antenna transmitting the radio signal with a predetermined output and the electronic device receiving the radio signal in a same electric field strength as the electric field strength.

2. The testing device according to claim 1, wherein the signal outputting section (200) is selected from a plurality of signal outputting sections, the testing device further comprises a storage section (311) that stores characteristic tables defining output characteristics of each of the plurality of signal outputting sections, and the converting section is specified with a signal outputting section from the plurality of signal outputting sections by an operation and obtains the electric field strength using a characteristic table defining the output characteristics of the specified signal outputting section from the characteristic tables stored in the storage section.

3. The testing device according to claim 1, wherein the converting section is provided with an electromagnetic damping factor through the transmitting section to the electronic device by an operation and obtains the electric field strength using the provided damping factor.

4. The testing device according to claim 1, wherein the transmitting section includes a first conducting plate (101) that has a width greater than the width of the electronic device and that is supplied with an electrical signal corresponding to the radio signal from outside and a second conducting plate (102) opposite the first conducting plate, the transmitting section is a stripline cell (100) that transmits the radio signal with an output corresponding to the electric power included in the electrical signal and that is arranged with the electronic device on the opposite side of the opposing surface of the first conducting plate opposite the second conducting plate, and the electrical signal outputted by the signal outputting section is supplied to the first conducting plate.

5. The testing device according to claim 1, further comprising
a reference electric field strength inputting section (303, 504) that accepts an input in relation to a reference electric field strength that needs to be converted to a predetermined reference distance by the conversion by the converting section, wherein
the converting section includes an initial relationship of a conversion relationship for converting the electric field strength to the distance, obtains a modified relationship by modifying the initial relationship so that the reference electric field strength of which the reference electric field strength inputting section has accepted the input is converted to the reference distance, and converts the electric field strength obtained from the output level specified by the specifying section to the distance between the antenna and the electronic device in accordance with the modified relationship.

6. The testing device according to claim 1, further comprising
a reference distance inputting section that accepts an input of a reference distance in which a predetermined reference electric field strength needs to be converted by the conversion by the converting section, wherein
the converting section includes an initial relationship of a conversion relationship for converting the electric field strength to the distance, obtains a modified relationship by modifying the initial relationship so that the reference electric field strength is converted to the reference distance of which the distance inputting section has accepted the input, and converts the electric field strength obtained from the output level specified by the specifying section to the distance between the antenna and the electronic device in accordance with the modified relationship.

7. The testing device according to claim 1, further comprising
a conversion result displaying section that displays a conversion result of the converting section.

8. The testing device according to claim 1, wherein
the specifying section sequentially specifies each of the plurality of output levels to the signal outputting section; and
the reaction checking section checks the reaction of the electronic device for each of the plurality of output levels.

9. The testing device according to claim 8, further comprising
a communication limit distance displaying section (313, 314, 315) that displays a distance, to which the converting section has converted a minimum output level among the output levels in which the reaction checking section has recognized the reaction of the electronic device, as a communication limit distance of the electronic device.

10. A testing method comprising:

specifying (S104) an output level to a signal outputting section that has unique output characteristics and that outputs a predetermined electrical signal with electric power corresponding to a specified output level with the output characteristics when the output level is specified from a plurality of output levels;
checking (S107) the existence of the reaction in an electronic device when a radio signal corresponding to the electrical signal outputted by the signal outputting section with electrical power corresponding to the output level specified in the specifying is transmitted to the electronic device that receives and reacts to the radio signal from a transmitting section that transmits the radio signal from a predetermined distance that is allowed to be a zero distance; and
converting (S105) by obtaining an electric field strength of the radio signal received by the electronic device using the output characteristics of the signal outputting section from the output level specified by the specifying section and by converting the electric field strength to a distance between a predetermined antenna and the electronic device, the antenna transmitting the radio signal with a predetermined output and the electronic device receiving the radio signal in a same electric field strength as the electric field strength.

# FIG. 1

# FIG. 2

EP 2 104 251 A2

# FIG. 3

300

- 304 INTERNAL TIMER
- 301 TEXT INPUTTING SECTION
- 302 TRIGGER INPUTTING SECTION
- 303 INPUT RECEIVING SECTION
- 305 OUTPUT LEVEL SETTING SECTION
- 306 OUTPUT LEVEL/ COMMAND CONSTRUCTING SECTION
- 307 OUTPUT LEVEL/ COMMAND TRANSMITTING SECTION
- 308 R/W INTERFACE SECTION
- 311 ELECTRIC FIELD STRENGTH STORAGE SECTION
- 310 RESPONSE ANALYZING SECTION
- 309 RESPONSE RECEIVING SECTION
- 314 TEXT DISPLAYING SECTION
- 313 DISPLAY PROCESSING SECTION
- 312 DISTANCE CALCULATION PROCESSING SECTION
- 315 GRAPHIC DISPLAYING SECTION

R/W

EP 2 104 251 A2

# FIG. 4

Tb1

| POS | ELECTRIC FIELD (dBm) | DISTANCE (cm) |
|---|---|---|
| 0 | 5.4 | 58 |
| 1 | 5.4 | 58 |
| 2 | 5.3 | 58 |
| 3 | 5.2 | 59 |
| 4 | 5.2 | 59 |
| 5 | 5.4 | 58 |
| 6 | 5.4 | 58 |
| 7 | 4.7 | 62 |
| 8 | 4.8 | 62 |
| 9 | 4.4 | 65 |
| 10 | 3.8 | 69 |
| 11 | 3.3 | 73 |
| 12 | 2.7 | 79 |
| 13 | 2.0 | 85 |
| 14 | 1.5 | 90 |
| 15 | 1.0 | 95 |
| 16 | 0.4 | 102 |
| 17 | 0.0 | 107 |
| 18 | −0.4 | 112 |
| 19 | −1.1 | 122 |
| 20 | −1.4 | 126 |
| 21 | −2.1 | 136 |
| 22 | −2.5 | 143 |
| 23 | −2.9 | 150 |
| 24 | −3.4 | 158 |
| 25 | −3.8 | 166 |
| 26 | −4.3 | 176 |
| 27 | −4.8 | 186 |
| 28 | −5.3 | 197 |
| 29 | −5.8 | 209 |
| 30 | −6.2 | 219 |

| POS | ELECTRIC FIELD (dBm) | DISTANCE (cm) |
|---|---|---|
| 31 | −6.7 | 232 |
| 32 | −7.2 | 245 |
| 33 | −7.8 | 263 |
| 34 | −8.1 | 272 |
| 35 | −8.9 | 299 |
| 36 | −9.0 | 302 |
| 37 | −9.8 | 331 |
| 38 | −10.3 | 351 |
| 39 | −10.8 | 372 |
| 40 | −11.2 | 389 |
| 41 | −11.5 | 403 |
| 42 | −11.2 | 389 |
| 43 | −11.4 | 398 |
| 44 | −11.5 | 403 |
| 45 | −11.2 | 389 |
| 46 | −11.3 | 394 |
| 47 | −11.3 | 394 |
| 48 | −11.2 | 389 |
| 49 | −11.3 | 394 |
| 50 | −11.4 | 398 |
| 51 | −11.3 | 394 |
| 52 | −11.3 | 394 |
| 53 | −11.5 | 403 |
| 54 | −11.5 | 403 |
| 55 | −11.5 | 403 |
| 56 | −11.3 | 394 |
| 57 | −11.4 | 398 |
| 58 | −11.6 | 407 |
| 59 | −11.5 | 403 |
| 60 | −11.4 | 398 |
| 61 | −11.4 | 398 |
| 62 | −11.4 | 398 |

# FIG. 5

FIG. 5 350

361

355  355a

355 FILE OPERATION

MEASUREMENT DIRECTION — 351
NEAR→FAR — 351a
NEAR←FAR — 351b

MANUAL SCAN — 352
MEASURE — 352a

AUTOMATIC SAVING — 354
SPECIFY AUTOMATIC SAVING — 354a
○ UID/EPC.txt
⊙ Date.txt — 354b

AUTO SCAN — 353
START BUTTON — 353a

《ACTIVATION LIMIT》 《《《 ←NEAR←FAR←《《《 ELECTRIC FIELD ⇒ DISTANCE＝112cm REFERENCE MODE

《RETENTION LIMIT》 《《《 ←NEAR← FAR←《《《 ELECTRIC FIELD ⇒ DISTANCE＝112cm REFERENCE MODE

FILE LIST

FILE NAME — 355b

SAVE  OPEN  DELETE  REFER

355c  355d  R/W#  355e  355f

362

ELECTRIC FIELD [dBm]

+10
0
-10
-20
-30

362a

363

365  366

DISTANCE=112cm  18

367

364b  364  364a

#2 ▽
356a  356a-1

ELECTRIC FIELD STRENGTH — 356
-0.4dBm(AROUNDTAG) — 356b

PORT
OPENING

AROUND TAG
EPC-C1G2

TRIMMING
SPECIFY

357  357a  358  358a  359  359a

EP 2 104 251 A2

# FIG. 6

START

357a — OPENING → OPEN COMMUNICATION PORT — S101

S102
· R/W
· TAG TYPE
· (TRIMMING)
· (AUTOMATIC SAVING)
· MEASUREMENT DIRECTION

VARIOUS INPUTS →

353a — AUTO START BUTTON , 352a — MANUAL MEASUREMENT

S103 MEASUREMENT ? N

Y

311 R/W#1 ⋮ R/W#n

S104 COMMAND PROCESS --- TRANSMIT COMMAND --->

S105 DISTANCE CALCULATION PROCESS

S106 DISPLAY ELECTRIC FIELD STRENGTH AND DISTANCE

S107 RESPONSE PROCESS

S108 RESPONSE ? N

S109 Y DISPLAY RESPONSE AND DISTANCE

S110 DISPLAY NO RESPONSE AND DISTANCE

S112 +1 or -1

352a — MANUAL MEASUREMENT , 304 — TIMER

S111 MEASUREMENT ? Y

N

S113 FINISHED ? N

Y

S114 SAVE

END

# FIG. 7

2

T1

41

500

200

42

100

# FIG. 8

# FIG. 9

Tb2a

| POS | R/W OUTPUT(dBm) | | Loss=15(dB)EXPECTED | | Loss=20(dB) MEASUREMENT1 | | Loss=10(dB) MEASUREMENT2 | |
|---|---|---|---|---|---|---|---|---|
| | EXPECTED VALUE | MEASUREMENT VALUE | ELECTRIC FIELD(dBm) | DISTANCE(cm) | ELECTRIC FIELD(dBm) | DISTANCE(cm) | ELECTRIC FIELD(dBm) | DISTANCE(cm) |
| 0 | 27.0 | 25.4 | 12.0 | 26.9 | 5.4 | 58 | 15.4 | 18 |
| 1 | 26.5 | 25.4 | 11.5 | 28.5 | 5.4 | 58 | 15.4 | 18 |
| 2 | 26.0 | 25.3 | 11.0 | 30.2 | 5.3 | 58 | 15.3 | 18 |
| 3 | 25.5 | 25.2 | 10.5 | 32.0 | 5.2 | 59 | 15.2 | 19 |
| 4 | 25.0 | 25.2 | 10.0 | 33.9 | 5.2 | 59 | 15.2 | 19 |
| 5 | 24.5 | 25.4 | 9.5 | 35.9 | 5.4 | 58 | 15.4 | 18 |
| 6 | 24.0 | 25.4 | 9.0 | 38.0 | 5.4 | 58 | 15.4 | 18 |
| 7 | 23.5 | 24.7 | 8.5 | 40.3 | 4.7 | 62 | 14.7 | 20 |
| 8 | 23.0 | 24.8 | 8.0 | 42.7 | 4.8 | 62 | 14.8 | 19 |
| 9 | 22.5 | 24.4 | 7.5 | 45.2 | 4.4 | 65 | 14.4 | 20 |
| 10 | 22.0 | 23.8 | 7.0 | 47.9 | 3.8 | 69 | 13.8 | 22 |
| 11 | 21.5 | 23.3 | 6.5 | 50.7 | 3.3 | 73 | 13.3 | 23 |
| 12 | 21.0 | 22.7 | 6.0 | 53.7 | 2.7 | 79 | 12.7 | 25 |
| 13 | 20.5 | 22.0 | 5.5 | 56.9 | 2.0 | 85 | 12.0 | 27 |
| 14 | 20.0 | 21.5 | 5.0 | 60.3 | 1.5 | 90 | 11.5 | 29 |
| 15 | 19.5 | 21.0 | 4.5 | 63.8 | 1.0 | 95 | 11.0 | 30 |
| 16 | 19.0 | 20.4 | 4.0 | 67.6 | 0.4 | 102 | 10.4 | 32 |
| 17 | 18.5 | 20.0 | 3.5 | 71.6 | 0.0 | 107 | 10.0 | 34 |
| 18 | 18.0 | 19.6 | 3.0 | 75.9 | −0.4 | 112 | 9.6 | 35 |
| 19 | 17.5 | 18.9 | 2.5 | 80.4 | −1.1 | 122 | 8.9 | 38 |
| 20 | 17.0 | 18.6 | 2.0 | 85.1 | −1.4 | 126 | 8.6 | 40 |
| 21 | 16.5 | 17.9 | 1.5 | 90.2 | −2.1 | 136 | 7.9 | 43 |
| 22 | 16.0 | 17.5 | 1.0 | 95.5 | −2.5 | 143 | 7.5 | 45 |
| 23 | 15.5 | 17.1 | 0.5 | 101.2 | −2.9 | 150 | 7.1 | 47 |
| 24 | 15.0 | 16.6 | 0.0 | 107.2 | −3.4 | 158 | 6.6 | 50 |
| 25 | 14.5 | 16.2 | −0.5 | 113.5 | −3.8 | 166 | 6.2 | 52 |
| 26 | 14.0 | 15.7 | −1.0 | 120.2 | −4.3 | 176 | 5.7 | 56 |
| 27 | 13.5 | 15.2 | −1.5 | 127.4 | −4.8 | 186 | 5.2 | 59 |
| 28 | 13.0 | 14.7 | −2.0 | 134.9 | −5.3 | 197 | 4.7 | 62 |
| 29 | 12.5 | 14.2 | −2.5 | 142.9 | −5.8 | 209 | 4.2 | 66 |
| 30 | 12.0 | 13.8 | −3.0 | 151.4 | −6.2 | 219 | 3.8 | 69 |

# FIG. 10

Tb2b

| POS | R/W OUTPUT(dBm) | | Loss=15(dB)EXPECTED | | Loss=20(dB) MEASUREMENT1 | | Loss=10(dB) MEASUREMENT2 | |
|---|---|---|---|---|---|---|---|---|
| | EXPECTED VALUE | MEASUREMENT VALUE | ELECTRIC FIELD(dBm) | DISTANCE(cm) | ELECTRIC FIELD(dBm) | DISTANCE(cm) | ELECTRIC FIELD(dBm) | DISTANCE(cm) |
| 31 | 11.5 | 13.3 | −3.5 | 160.3 | −6.7 | 232 | 3.3 | 73 |
| 32 | 11.0 | 12.8 | −4.0 | 169.8 | −7.2 | 245 | 2.8 | 78 |
| 33 | 10.5 | 12.2 | −4.5 | 179.9 | −7.8 | 263 | 2.2 | 83 |
| 34 | 10.0 | 11.9 | −5.0 | 190.5 | −8.1 | 272 | 1.9 | 86 |
| 35 | 9.5 | 11.1 | −5.5 | 201.8 | −8.9 | 299 | 1.1 | 94 |
| 36 | 9.0 | 11.0 | −6.0 | 213.8 | −9.0 | 302 | 1.0 | 95 |
| 37 | 8.5 | 10.2 | −6.5 | 226.5 | −9.8 | 331 | 0.2 | 105 |
| 38 | 8.0 | 9.7 | −7.0 | 239.9 | −10.3 | 351 | −0.3 | 111 |
| 39 | 7.5 | 9.2 | −7.5 | 254.1 | −10.8 | 372 | −0.8 | 117 |
| 40 | 7.0 | 8.8 | −8.0 | 269.2 | −11.2 | 389 | −1.2 | 123 |
| 41 | 6.5 | 8.5 | −8.5 | 285.1 | −11.5 | 403 | −1.5 | 127 |
| 42 | 6.0 | 8.8 | −9.0 | 302.0 | −11.2 | 389 | −1.2 | 123 |
| 43 | 5.5 | 8.6 | −9.5 | 319.9 | −11.4 | 398 | −1.4 | 126 |
| 44 | 5.0 | 8.5 | −10.0 | 339.8 | −11.5 | 403 | −1.5 | 127 |
| 45 | 4.5 | 8.8 | −10.5 | 358.9 | −11.2 | 389 | −1.2 | 123 |
| 46 | 4.0 | 8.7 | −11.0 | 380.2 | −11.3 | 394 | −1.3 | 124 |
| 47 | 3.5 | 8.7 | −11.5 | 402.7 | −11.3 | 394 | −1.3 | 124 |
| 48 | 3.0 | 8.8 | −12.0 | 426.6 | −11.2 | 389 | −1.2 | 123 |
| 49 | 2.5 | 8.7 | −12.5 | 451.9 | −11.3 | 394 | −1.3 | 124 |
| 50 | 2.0 | 8.6 | −13.0 | 478.6 | −11.4 | 398 | −1.4 | 126 |
| 51 | 1.5 | 8.7 | −13.5 | 507.0 | −11.3 | 394 | −1.3 | 124 |
| 52 | 1.0 | 8.7 | −14.0 | 537.0 | −11.3 | 394 | −1.3 | 124 |
| 53 | 0.5 | 8.5 | −14.5 | 568.9 | −11.5 | 403 | −1.5 | 127 |
| 54 | 0.0 | 8.5 | −15.0 | 602.6 | −11.5 | 403 | −1.5 | 127 |
| 55 | −0.5 | 8.5 | −15.5 | 638.3 | −11.5 | 403 | −1.5 | 127 |
| 56 | −1.0 | 8.7 | −16.0 | 676.1 | −11.3 | 394 | −1.3 | 124 |
| 57 | −1.5 | 8.6 | −16.5 | 716.1 | −11.4 | 398 | −1.4 | 126 |
| 58 | −2.0 | 8.4 | −17.0 | 758.6 | −11.6 | 407 | −1.6 | 129 |
| 59 | −2.5 | 8.5 | −17.5 | 803.5 | −11.5 | 403 | −1.5 | 127 |
| 60 | −3.0 | 8.6 | −18.0 | 851.1 | −11.4 | 398 | −1.4 | 126 |
| 61 | −3.5 | 8.6 | −18.5 | 901.6 | −11.4 | 398 | −1.4 | 126 |
| 62 | −4.0 | 8.6 | −19.0 | 955.0 | −11.4 | 398 | −1.4 | 126 |

FIG. 11

FIG. 12

550

FIG. 13

EP 2 104 251 A2

# FIG. 14

# FIG. 15

EP 2 104 251 A2

# FIG. 16

G4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006322915 A